(19) **Europäisches Patentamt / European Patent Office / Office européen des brevets**

(11) **EP 4 761 120 A1**

(12) **EUROPEAN PATENT APPLICATION**
published in accordance with Art. 153(4) EPC

(43) Date of publication:
**17.06.2026 Bulletin 2026/25**

(21) Application number: **23950038.2**

(22) Date of filing: **28.08.2023**

(51) International Patent Classification (IPC):
**H03M 13/13** $^{(2006.01)}$

(52) Cooperative Patent Classification (CPC):
**H03M 13/13**

(86) International application number:
**PCT/CN2023/115283**

(87) International publication number:
**WO 2025/043444 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **HUAWEI TECHNOLOGIES CO., LTD.**
**Shenzhen 518129 (CN)**

(72) Inventors:
• **QIN, Kangjian**
  **Shenzhen, Guangdong 518129 (CN)**
• **ZHANG, Huazi**
  **Shenzhen, Guangdong 518129 (CN)**
• **WANG, Xianbin**
  **Shenzhen, Guangdong 518129 (CN)**
• **TONG, Jiajie**
  **Shenzhen, Guangdong 518129 (CN)**
• **LIU, Ke**
  **Shenzhen, Guangdong 518129 (CN)**
• **WANG, Jun**
  **Shenzhen, Guangdong 518129 (CN)**
• **DU, Yinggang**
  **Shenzhen, Guangdong 518129 (CN)**

(74) Representative: **Maiwald GmbH**
**Engineering**
**Elisenhof**
**Elisenstrasse 3**
**80335 München (DE)**

(54) **POLAR CODE ENCODING METHOD AND APPARATUS**

(57) A polar code encoding method and an apparatus are provided and relate to the field of communication technologies, to enable polar codes to be constructed based on a same reliability sequence and a same first matrix for sequences of different quantities of information bits, thereby reducing hardware complexity and improving decoding performance. The method includes: mapping, based on a reliability sequence whose length is N, an information bit sequence whose length is k to k bits of a first sequence whose length is N, to obtain a second sequence including k information bit positions, x PC bit positions, and N-k-x frozen bit positions; multiplying the second sequence by a first matrix to obtain a third sequence; and performing polar encoding to obtain a fourth sequence, where $k \leq K \leq N$, $1 \leq x$, K is a maximum value of the length of the information bit sequence, k, K, N, and x are all positive integers, there are all 0s below a diagonal of the first matrix, and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 is less than or equal to N-K.

A transmit end device maps, based on a reliability sequence, an information bit sequence whose length is k to k bits of a first sequence whose length is N, to obtain a second sequence — 701

The transmit end device multiplies the second sequence by a first matrix to obtain a third sequence — 702

The transmit end device performs polar encoding on the third sequence to obtain a fourth sequence — 703

FIG. 7

**Description**

**TECHNICAL FIELD**

Embodiments of this application relate to the field of communication technologies, and in particular, to a polar code encoding method and an apparatus.

**BACKGROUND**

In a communication system, to reduce coding complexity, a coding scheme based on a parity-check polar code (parity check polar codes, PC-Polar codes) is proposed.

The PC-Polar code may include an information bit position, a frozen bit position, a PC bit position, and a rate matching shortened bit position. The information bit position is used to carry an information bit, the frozen bit position is used to carry a frozen bit, and the PC bit position is used to carry a PC bit. The PC bit position is determined based on the information bit position, a value of the PC bit may be determined by using a PC equation based on a value of an information bit located before the PC bit position, and the rate matching shortened bit position does not need to be sent to a channel.

For sequences of different quantities of information bits, positions of information bits of the sequences are different, leading to different PC bit positions and PC equations. In other words, corresponding PC bit positions and PC equations need to be separately stored for the sequences of different quantities of information bits, resulting in higher hardware complexity and higher hardware overheads.

**SUMMARY**

This application provides a polar code encoding method and an apparatus, to enable polar codes to be constructed based on a same reliability sequence and a same first matrix for sequences of different quantities of information bits, thereby reducing hardware complexity, reducing hardware overheads, improving code spectrum characteristics, reducing decoding complexity, and improving decoding performance.

According to a first aspect, an embodiment of this application provides a polar code encoding method. An execution body of the method may be a transmit end device, or may be a chip, a chip system, or a system on chip of a transmit end device. The method includes: The transmit end device maps, based on a reliability sequence, an information bit sequence whose length is k to k bits of a first sequence whose length is N, to obtain a second sequence; multiplies the second sequence by a first matrix to obtain a third sequence; and performs polar encoding on the third sequence to obtain a fourth sequence, where a length of the reliability sequence is N, the second sequence includes k information bit positions, x parity check PC bit positions, and N-k-x frozen bit positions, $k \leq K \leq N$, $1 \leq x$, K is a maximum value of the length of the information bit sequence, k, K, N, and x are all positive integers, the first matrix is a matrix with all 0s below a diagonal and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 in the first matrix is less than or equal to N-K.

According to the first aspect, this embodiment of this application provides a coding scheme based on a nested PC polar code, to separately construct, for an information bit sequence, a reliability sequence whose length is N and that has a nesting characteristic. In this way, when puncturing is performed in a back-to-front order, a quantity of performance bad points is reduced, code spectrum characteristics are improved, and decoding performance is improved. In addition, in this embodiment of this application, polar codes can be constructed based on a same first matrix for sequences of different quantities of information bits, that is, the first matrix has a nesting characteristic for the sequences of different quantities of information bits, and the first matrix does not change with a change of a quantity of information bits of the sequences; or it may be described that PC bit positions and PC equations corresponding to the sequences of different quantities of information bits are nested, and the transmit end device can store the same first matrix for the information bit sequences of different lengths, and does not need to separately store corresponding PC bit positions and PC equations for the information bit sequences of different lengths, thereby reducing hardware complexity, reducing hardware overheads, improving code spectrum characteristics, reducing decoding complexity, and improving decoding performance.

In a possible design, multiplying the second sequence by the first matrix to obtain the third sequence includes: determining, based on the first matrix, one or more PC bit positions and bits checked by the PC bit positions; and determining a value of the PC bit position in the second sequence based on a value of the bit checked by the PC bit position, to obtain the third sequence.

Based on this possible design, when the second sequence is processed based on the first matrix, the one or more PC bit positions of the second sequence may be determined based on the column whose column weight is greater than 1 in the first matrix, and then a value of each PC bit position in the second sequence is determined based on each bit checked by the PC bit position. For example, an exclusive OR result of the value of the bit checked by the PC bit position may be used as the value of the PC bit position. This provides a feasible solution for processing the second sequence based on the first matrix to obtain the third sequence.

In a possible design, the reliability sequence is determined based on one or more of the following: reliability, a code spectrum, and a performance optimization result.

Based on this possible design, the reliability sequence whose length is N may be separately constructed for the information bit sequence based on parameters such as the reliability, the code spectrum, and the performance optimization result. When an encoded sequence is subsequently punctured in a back-to-front order, a quantity of performance bad points can be reduced, code spectrum characteristics can be improved, and decoding performance can be improved.

In a possible design, a column weight of the first matrix is less than or equal to a first value.

Based on this possible design, the column weight of the first matrix may be less than or equal to the first value, thereby ensuring sparseness of the first matrix, and obtaining better code spectrum characteristics.

In a possible design, the first matrix is:

$$
\begin{bmatrix}
10000000000000000000000000000000 \\
01000000000000000000000000000000 \\
00100000000000000000000000000000 \\
00010000000000000000000000000000 \\
00001000000000000000000000000000 \\
00000100000000000000000000000000 \\
00000010000000000000000000000000 \\
00000001000000000000000000000000 \\
00000000100000000000000000000000 \\
00000000010000000000000000000000 \\
00000000001000000000000000000000 \\
00000000000100000100000000000000 \\
00000000000010000000000000000000 \\
00000000000001001010000000000000 \\
00000000000000100000010000000000 \\
00000000000000010010000000000000 \\
00000000000000001000000000000000 \\
00000000000000000100000000000000 \\
00000000000000000010000000000000 \\
00000000000000000001000000000000 \\
00000000000000000000100000000000 \\
00000000000000000000010000000000 \\
00000000000000000000001001000000 \\
00000000000000000000000100000000 \\
00000000000000000000000010000000 \\
00000000000000000000000001000000 \\
00000000000000000000000000100000 \\
00000000000000000000000000010000 \\
00000000000000000000000000001000 \\
00000000000000000000000000000100 \\
00000000000000000000000000000010 \\
00000000000000000000000000000001
\end{bmatrix}.
$$

In a possible design, the first matrix is:

$$
\begin{bmatrix}
1000000000000000000000000000000 \\
0100000000000000000000000000000 \\
0010000000000000000000000000000 \\
0001000000000000000000000000000 \\
0000100000000000000000000000000 \\
0000010000000000000000000000000 \\
0000001000000000000000000000000 \\
0000000100000000000000000000000 \\
0000000010000000000000000000000 \\
0000000001000000000000000000000 \\
0000000000100000000000000000000 \\
0000000000010000000010000000000 \\
0000000000001000000000000000000 \\
0000000000000100000000000100000 \\
0000000000000010001010001000000 \\
0000000000000001000000000000000 \\
0000000000000000100000000000000 \\
0000000000000000010000000000000 \\
0000000000000000001000000000000 \\
0000000000000000000100000000000 \\
0000000000000000000010000000000 \\
0000000000000000000001000000000 \\
0000000000000000000000100000000 \\
0000000000000000000000011000000 \\
0000000000000000000000001000000 \\
0000000000000000000000000100000 \\
0000000000000000000000000010000 \\
0000000000000000000000000001000 \\
0000000000000000000000000000100 \\
0000000000000000000000000000010 \\
0000000000000000000000000000001
\end{bmatrix}.
$$

Based on the foregoing two possible designs, a plurality of feasible solutions are provided for designing the first matrix.

In a possible design, the third sequence includes the one or more PC bit positions, and a difference between a number of the PC bit position and a number of the bit checked by the PC bit position is a prime number.

Based on this possible design, the difference between the number of the PC bit position and the number of the bit checked by the PC bit position is limited to be a prime number. This can greatly reduce search space, and reduce loss of optimality as much as possible while improving code spectrum characteristics.

In a possible design, the PC bit position of the third sequence is one or more of the following bits in the third sequence: 16, 18, 21, or 25.

In a possible design, when the PC bit position is the 16th bit in the third sequence, the bit checked by the PC bit position is a 13th bit in the third sequence; or when the PC bit position is the 18th bit in the third sequence, the bit checked by the PC bit position is one or more of the following bits in the third sequence: 11, 13, and 15; or when the PC bit position is the 21st bit in the third sequence, the bit checked by the PC bit position is a 14th bit in the third sequence; or when the PC bit position is the 25th bit in the third sequence, the bit checked by the PC bit position is a 22nd bit in the third sequence.

Based on the foregoing two possible designs, a preferred example is provided for the PC bit position and the bit checked by the PC bit position. This can greatly reduce search space, reduce loss of optimality as much as possible while obtaining better code spectrum characteristics, reduce decoding complexity, and improve decoding performance.

In a possible design, the PC bit position of the third sequence is one or more of the following bits in the third sequence: 19, 21, 25, or 26.

In a possible design, when the PC bit position is the 19th bit in the third sequence, the bit checked by the PC bit position is a 14th bit in the third sequence; or when the PC bit position is the 21st bit in the third sequence, the bit checked by the PC bit position is one or more of the following bits in the third sequence: 11 and 14; or when the PC bit position is the 25th bit in the third sequence, the bit checked by the PC bit position is one or more of the following bits in the third sequence: 14 and 22; or when the PC bit position is the 26th bit in the third sequence, the bit checked by the PC bit position is a 13th bit in the third sequence.

Based on the foregoing two possible designs, another preferred example is provided for the PC bit position and the bit checked by the PC bit position. This can greatly reduce search space, reduce loss of optimality as much as possible while obtaining better code spectrum characteristics, reduce decoding complexity, and improve decoding performance.

In a possible design, the method further includes: performing interleaving processing on the fourth sequence based on a first interleaving pattern, to obtain a fifth sequence; and performing rate matching on the fifth sequence to obtain a first rate matching sequence.

Based on this possible design, the first interleaving pattern may be an interleaving pattern determined based on sequence performance and a nesting characteristic, so that there is no need to separately store an interleaving pattern for sequences of different quantities of information bits, thereby reducing hardware complexity and reducing hardware overheads. In addition, because the first interleaving pattern is determined based on sequence performance, it can be ensured that there is no bad point in rate matching performance (for example, there is no bad point in 1-bit fine-grained rate matching performance), and decoding performance is improved.

In a possible design, the first interleaving pattern indicates to place a value of an $A^{th}$ bit of the fourth sequence in a $B^{th}$ bit of the fifth sequence through swapping; and a mapping relationship between A and B is: (5, 31), (26, 30), (11, 29), (9, 28), (28, 27), (7, 26), (30, 25), (16, 24), (31, 23), (21, 22), (10, 21), (24, 20), (27, 19), (6, 18), (3, 17), (12, 16), (17, 15), (8, 14), (13, 13), (0, 12), (2, 11), (1, 10), (4, 9), (14, 8), (25, 7), (23, 6), (22, 5), and (19, 4).

In a possible design, the first interleaving pattern indicates to place a value of an $A^{th}$ bit of the fourth sequence in a $B^{th}$ bit of the fifth sequence through swapping; and a mapping relationship between A and B is: (4, 31), (22, 30), (27, 29), (17, 28), (8, 27), (2, 26), (15, 25), (21, 24), (29, 23), (23, 22), (6, 21), (26, 20), (20, 19), (7, 18), (0, 17), (13, 16), (19, 15), (11, 14), (14, 13), (16, 12), (25, 11), (3, 10), (10, 9), (5, 8), (12, 7), (1, 6), (18, 5), and (24, 4).

Based on the foregoing two possible designs, two preferred examples are provided for the first interleaving pattern. This can ensure that there is no bad point in rate matching performance while having a nesting characteristic, and improve decoding performance.

In a possible design, the method further includes: performing interleaving processing on the fourth sequence based on a second interleaving pattern, to obtain a sixth sequence; and performing rate matching on the sixth sequence to obtain a second rate matching sequence.

Based on this possible design, different from the first interleaving pattern that has a nesting characteristic in the first possible design, corresponding second interleaving patterns may be separately designed for sequences of different quantities of information bits, that is, the sequences of different quantities of information bits may correspond to different second interleaving patterns, to better fit the sequences of different quantities of information bits, ensure that there is no bad point in rate matching performance, and improve decoding performance.

In a possible design, the second interleaving pattern indicates to place a value of an $A^{th}$ bit of the fourth sequence in a $B^{th}$ bit of the sixth sequence through swapping; and a mapping relationship between A and B is: (12, 31), (9, 30), (19, 29), (18, 28), (1, 27), (15, 26), (14, 25), (29, 24), (16, 23), (10, 22), (28, 21), (23, 20), (20, 19), (6, 18), (21, 17), (7, 16), (2, 15), (25, 14), (0, 13), (3, 12), (5, 11), (31, 10), (30, 9), (4, 8), (22, 7), (13, 6), (27, 5), and (8, 4).

In a possible design, the second interleaving pattern indicates to place a value of an $A^{th}$ bit of the fourth sequence in a $B^{th}$ bit of the sixth sequence through swapping; and a mapping relationship between A and B is: (18, 31), (29, 30), (9, 29), (12, 28), (27, 27), (22, 26), (23, 25), (26, 24), (4, 23), (0, 22), (7, 21), (14, 20), (8, 19), (19, 18), (1, 17), (21, 16), (13, 15), (11, 14), (17, 13), (20, 12), (16, 11), (15, 10), (6, 9), (10, 8), (28, 7), (25, 6), and (24, 5).

In a possible design, the second interleaving pattern indicates to place a value of an $A^{th}$ bit of the fourth sequence in a $B^{th}$ bit of the sixth sequence through swapping; and a mapping relationship between A and B is: (2, 31), (20, 30), (12, 29), (25, 28), (8, 27), (22, 26), (16, 25), (5, 24), (29, 23), (14, 22), (23, 21), (15, 20), (3, 19), (11, 18), (10, 17), (17, 16), (0, 15), (30, 14), (18, 13), (27, 12), (4, 11), (19, 10), (21, 9), (6, 8), (26, 7), and (9, 6).

In a possible design, the second interleaving pattern indicates to place a value of an $A^{th}$ bit of the fourth sequence in a $B^{th}$ bit of the sixth sequence through swapping; and a mapping relationship between A and B is: (19, 31), (23, 30), (16, 29), (18, 28), (29, 27), (0, 26), (21, 25), (8, 24), (11, 23), (4, 22), (13, 21), (2, 20), (20, 19), (24, 18), (25, 17), (6, 16), (28, 15), (14, 14), (10, 13), (9, 12), (31, 11), (26, 10), (7, 9), (17, 8), and (1, 7).

In a possible design, the second interleaving pattern indicates to place a value of an $A^{th}$ bit of the fourth sequence in a $B^{th}$ bit of the sixth sequence through swapping; and a mapping relationship between A and B is: (7, 31), (9, 30), (19, 29), (26, 28), (31, 27), (21, 26), (27, 25), (2, 24), (23, 23), (17, 22), (10, 21), (30, 20), (25, 19), (24, 18), (0, 17), (16, 16), (4, 15), (11, 14), (20, 13), (12, 12), (29, 11), (18, 10), (13, 9), and (3, 8).

In a possible design, the second interleaving pattern indicates to place a value of an $A^{th}$ bit of the fourth sequence in a $B^{th}$ bit of the sixth sequence through swapping; and a mapping relationship between A and B is: (15, 31), (16, 30), (9, 29), (14, 28), (17, 27), (24, 26), (21, 25), (20, 24), (5, 23), (1, 22), (7, 21), (30, 20), (11, 19), (6, 18), (2, 17), (3, 16), (8, 15), (22, 14), (12, 13), (23, 12), (19, 11), (10, 10), and (29, 9).

In a possible design, the second interleaving pattern indicates to place a value of an $A^{th}$ bit of the fourth sequence in a $B^{th}$ bit of the sixth sequence through swapping; and a mapping relationship between A and B is: (17, 31), (21, 30), (15, 29), (14, 28), (4, 27), (24, 26), (8, 25), (29, 24), (19, 23), (16, 22), (7, 21), (2, 20), (9, 19), (25, 18), (26, 17), (23, 16), (28, 15), (30, 14), (13, 13), (6, 12), (22, 11), and (0, 10).

In a possible design, the second interleaving pattern indicates to place a value of an $A^{th}$ bit of the fourth sequence in a $B^{th}$ bit of the sixth sequence through swapping; and a mapping relationship between A and B is: (28, 31), (29, 30), (14, 29), (26, 28), (8, 27), (23, 26), (24, 25), (30, 24), (0, 23), (31, 22), (10, 21), (5, 20), (20, 19), (4, 18), (16, 17), (12, 16), (9, 15), (21, 14), (1, 13), (11, 12), and (22, 11).

In a possible design, the second interleaving pattern indicates to place a value of an $A^{th}$ bit of the fourth sequence in a $B^{th}$ bit of the sixth sequence through swapping; and a mapping relationship between A and B is: (22, 31), (19, 30), (28, 29), (9, 28), (4, 27), (6, 26), (14, 25), (11, 24), (3, 23), (13, 22), (0, 21), (15, 20), (26, 19), (24, 18), (27, 17), (18, 16), (21, 15), (17, 14), (20, 13), and (12, 12).

Based on the foregoing nine possible designs, a possible second interleaving pattern is separately provided when k is equal to 3 to 11, that is, corresponding second interleaving patterns are separately designed for sequences of different quantities of information bits, to ensure that there is no bad point in rate matching performance and improve decoding performance.

In a possible design, the second interleaving pattern indicates to place a value of an $A^{th}$ bit of the fourth sequence in a $B^{th}$ bit of the sixth sequence through swapping; and a mapping relationship between A and B is: (5, 31), (11, 30), (24, 29), (30, 28), (13, 27), (20, 26), (22, 25), (3, 24), (4, 23), (25, 22), (31, 21), (6, 20), (10, 19), (8, 18), (21, 17), (15, 16), (9, 15), (2, 14), (0, 13), (27, 12), (14, 11), (16, 10), (17, 9), (23, 8), (28, 7), (26, 6), (1, 5), and (7, 4).

In a possible design, the second interleaving pattern indicates to place a value of an $A^{th}$ bit of the fourth sequence in a $B^{th}$ bit of the sixth sequence through swapping; and a mapping relationship between A and B is: (16, 31), (28, 30), (10, 29), (30, 28), (19, 27), (7, 26), (13, 25), (9, 24), (11, 23), (6, 22), (8, 21), (26, 20), (21, 19), (20, 18), (23, 17), (25, 16), (0, 15), (17, 14), (27, 13), (22, 12), (18, 11), (15, 10), (5, 9), (12, 8), (2, 7), (29, 6), and (24, 5).

In a possible design, the second interleaving pattern indicates to place a value of an $A^{th}$ bit of the fourth sequence in a $B^{th}$ bit of the sixth sequence through swapping; and a mapping relationship between A and B is: (9, 31), (19, 30), (11, 29), (12, 28), (21, 27), (0, 26), (29, 25), (2, 24), (4, 23), (31, 22), (10, 21), (1, 20), (22, 19), (7, 18), (24, 17), (30, 16), (20, 15), (3, 14), (28, 13), (13, 12), (14, 11), (8, 10), (6, 9), (5, 8), (17, 7), and (18, 6).

In a possible design, the second interleaving pattern indicates to place a value of an $A^{th}$ bit of the fourth sequence in a $B^{th}$ bit of the sixth sequence through swapping; and a mapping relationship between A and B is: (11, 31), (25, 30), (31, 29), (27, 28), (14, 27), (0, 26), (22, 25), (19, 24), (18, 23), (3, 22), (20, 21), (2, 20), (4, 19), (17, 18), (23, 17), (24, 16), (12, 15), (1, 14), (7, 13), (10, 12), (28, 11), (26, 10), (6, 9), (5, 8), and (8, 7).

In a possible design, the second interleaving pattern indicates to place a value of an $A^{th}$ bit of the fourth sequence in a $B^{th}$ bit of the sixth sequence through swapping; and a mapping relationship between A and B is: (7, 31), (12, 30), (2, 29), (5, 28), (26, 27), (6, 26), (27, 25), (24, 24), (4, 23), (19, 22), (1, 21), (29, 20), (9, 19), (8, 18), (13, 17), (11, 16), (28, 15), (10, 14), (25, 13), (16, 12), (30, 11), (0, 10), (21, 9), and (3, 8).

In a possible design, the second interleaving pattern indicates to place a value of an $A^{th}$ bit of the fourth sequence in a $B^{th}$ bit of the sixth sequence through swapping; and a mapping relationship between A and B is: (7, 31), (30, 30), (17, 29), (16, 28), (19, 27), (6, 26), (29, 25), (18, 24), (10, 23), (3, 22), (24, 21), (9, 20), (21, 19), (28, 18), (31, 17), (12, 16), (23, 15), (2, 14), (15, 13), (4, 12), (27, 11), (20, 10), and (25, 9).

In a possible design, the second interleaving pattern indicates to place a value of an $A^{th}$ bit of the fourth sequence in a $B^{th}$ bit of the sixth sequence through swapping; and a mapping relationship between A and B is: (28, 31), (25, 30), (17, 29), (6, 28), (11, 27), (21, 26), (27, 25), (30, 24), (3, 23), (1, 22), (4, 21), (8, 20), (15, 19), (26, 18), (29, 17), (18, 16), (9, 15), (19, 14), (2, 13), (20, 12), (23, 11), and (10, 10).

In a possible design, the second interleaving pattern indicates to place a value of an $A^{th}$ bit of the fourth sequence in a $B^{th}$ bit of the sixth sequence through swapping; and a mapping relationship between A and B is: (23, 31), (30, 30), (3, 29), (28, 28), (14, 27), (19, 26), (9, 25), (16, 24), (29, 23), (13, 22), (26, 21), (12, 20), (18, 19), (0, 18), (15, 17), (4, 16), (20, 15), (1, 14), (25, 13), (31, 12), and (21, 11).

In a possible design, the second interleaving pattern indicates to place a value of an $A^{th}$ bit of the fourth sequence in a $B^{th}$ bit of the sixth sequence through swapping; and a mapping relationship between A and B is: (1, 31), (24, 30), (14, 29), (15, 28), (25, 27), (12, 26), (26, 25), (13, 24), (27, 23), (31, 22), (8, 21), (5, 20), (20, 19), (21, 18), (3, 17), (28, 16), (17, 15), (6, 14), (19, 13), and (11, 12).

Based on the foregoing nine possible designs, another possible second interleaving pattern is separately provided when k is equal to 3 to 11, that is, corresponding second interleaving patterns are separately designed for sequences of different quantities of information bits, to ensure that there is no bad point in rate matching performance and improve decoding performance.

According to a second aspect, an embodiment of this application provides a communication apparatus. The communication apparatus may be used in the transmit end device in the first aspect, to implement a function performed by the transmit end device. The communication apparatus may be a transmit end device, or may be a chip, a chip system, a system on chip, or the like of the transmit end device. The communication apparatus may perform, by hardware or by hardware by executing corresponding software, the function performed by the transmit end device. The hardware or the software includes one or more modules corresponding to the foregoing function, for example, a transceiver module and a processing module. The transceiver module may independently complete the following receiving and sending operations, or may cooperate with the processing module to complete the following receiving and sending operations. Correspondingly, the processing module may independently complete the following processing operation, or may cooperate with the transceiver module to complete the following processing operation. This is not limited.

The processing module is configured to map, based on a reliability sequence, an information bit sequence whose length is k to k bits of a first sequence whose length is N, to obtain a second sequence; and is further configured to: multiply the second sequence by a first matrix to obtain a third sequence; and perform polar encoding on the third sequence to obtain a fourth sequence, where a length of the reliability sequence is N, the second sequence includes k information bit positions, x parity check PC bit positions, and N-k-x frozen bit positions, $k \leq K \leq N$, $1 \leq x$, K is a maximum value of the length of the information bit sequence, k, K, N, and x are all positive integers, the first matrix is a matrix with all 0s below a diagonal and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 in the first matrix is less than or equal to N-K.

In a possible design, the processing module is specifically configured to: determine, based on the first matrix, one or more PC bit positions and bits checked by the PC bit positions; and determine a value of the PC bit position in the second sequence based on a value of the bit checked by the PC bit position, to obtain the third sequence.

In a possible design, the reliability sequence is determined based on one or more of the following: reliability, a code spectrum, and a performance optimization result.

In a possible design, a column weight of the first matrix is less than or equal to a first value.

In a possible design, the third sequence includes the one or more PC bit positions, and a difference between a number of the PC bit position and a number of the bit checked by the PC bit position is a prime number.

In a possible design, the PC bit position of the third sequence is one or more of the following bits in the third sequence: 16, 18, 21, or 25.

In a possible design, when the PC bit position is the 16th bit in the third sequence, the bit checked by the PC bit position is a 13th bit in the third sequence; or when the PC bit position is the 18th bit in the third sequence, the bit checked by the PC bit position is one or more of the following bits in the third sequence: 11, 13, and 15; or when the PC bit position is the 21st bit in the third sequence, the bit checked by the PC bit position is a 14th bit in the third sequence; or when the PC bit position is the 25th bit in the third sequence, the bit checked by the PC bit position is a 22nd bit in the third sequence.

In a possible design, the PC bit position of the third sequence is one or more of the following bits in the third sequence: 19, 21, 25, or 26.

In a possible design, when the PC bit position is the 19th bit in the third sequence, the bit checked by the PC bit position is a 14th bit in the third sequence; or when the PC bit position is the 21st bit in the third sequence, the bit checked by the PC bit position is one or more of the following bits in the third sequence: 11 and 14; or when the PC bit position is the 25th bit in the third sequence, the bit checked by the PC bit position is one or more of the following bits in the third sequence: 14 and 22; or when the PC bit position is the 26th bit in the third sequence, the bit checked by the PC bit position is a 13th bit in the third sequence.

In a possible design, the first matrix is:

$$\begin{bmatrix}
1000000000000000000000000000000 \\
0100000000000000000000000000000 \\
0010000000000000000000000000000 \\
0001000000000000000000000000000 \\
0000100000000000000000000000000 \\
0000010000000000000000000000000 \\
0000001000000000000000000000000 \\
0000000100000000000000000000000 \\
0000000010000000000000000000000 \\
0000000001000000000000000000000 \\
0000000000100000000000000000000 \\
0000000000010000010000000000000 \\
0000000000001000000000000000000 \\
0000000000000100101000000000000 \\
0000000000000010000010000000000 \\
0000000000000001001000000000000 \\
0000000000000000100000000000000 \\
0000000000000000010000000000000 \\
0000000000000000001000000000000 \\
0000000000000000000100000000000 \\
0000000000000000000010000000000 \\
0000000000000000000001000000000 \\
0000000000000000000000100100000 \\
0000000000000000000000010000000 \\
0000000000000000000000001000000 \\
0000000000000000000000000100000 \\
0000000000000000000000000010000 \\
0000000000000000000000000001000 \\
0000000000000000000000000000100 \\
0000000000000000000000000000010 \\
0000000000000000000000000000001
\end{bmatrix}.$$

In a possible design, the first matrix is:

8

$$\begin{bmatrix}
10000000000000000000000000000000 \\
01000000000000000000000000000000 \\
00100000000000000000000000000000 \\
00010000000000000000000000000000 \\
00001000000000000000000000000000 \\
00000100000000000000000000000000 \\
00000010000000000000000000000000 \\
00000001000000000000000000000000 \\
00000000100000000000000000000000 \\
00000000010000000000000000000000 \\
00000000001000000000000000000000 \\
00000000000100000000100000000000 \\
00000000000010000000000000000000 \\
00000000000001000000000100000000 \\
00000000000000100001010001000000 \\
00000000000000010000000000000000 \\
00000000000000001000000000000000 \\
00000000000000000100000000000000 \\
00000000000000000010000000000000 \\
00000000000000000001000000000000 \\
00000000000000000000100000000000 \\
00000000000000000000010000000000 \\
00000000000000000000001001000000 \\
00000000000000000000000100000000 \\
00000000000000000000000010000000 \\
00000000000000000000000001000000 \\
00000000000000000000000000100000 \\
00000000000000000000000000010000 \\
00000000000000000000000000001000 \\
00000000000000000000000000000100 \\
00000000000000000000000000000010 \\
00000000000000000000000000000001
\end{bmatrix}.$$

In a possible design, the processing module is further configured to: perform interleaving processing on the fourth sequence based on a first interleaving pattern, to obtain a fifth sequence; and perform rate matching on the fifth sequence to obtain a first rate matching sequence.

In a possible design, the first interleaving pattern indicates to place a value of an $A^{th}$ bit of the fourth sequence in a $B^{th}$ bit of the fifth sequence through swapping; and a mapping relationship between A and B is: (5, 31), (26, 30), (11, 29), (9, 28), (28, 27), (7, 26), (30, 25), (16, 24), (31, 23), (21, 22), (10, 21), (24, 20), (27, 19), (6, 18), (3, 17), (12, 16), (17, 15), (8, 14), (13, 13), (0, 12), (2, 11), (1, 10), (4, 9), (14, 8), (25, 7), (23, 6), (22, 5), and (19, 4).

In a possible design, the first interleaving pattern indicates to place a value of an $A^{th}$ bit of the fourth sequence in a $B^{th}$ bit of the fifth sequence through swapping; and a mapping relationship between A and B is: (4, 31), (22, 30), (27, 29), (17, 28), (8, 27), (2, 26), (15, 25), (21, 24), (29, 23), (23, 22), (6, 21), (26, 20), (20, 19), (7, 18), (0, 17), (13, 16), (19, 15), (11, 14), (14, 13), (16, 12), (25, 11), (3, 10), (10, 9), (5, 8), (12, 7), (1, 6), (18, 5), and (24, 4).

In a possible design, the processing module is further configured to: perform interleaving processing on the fourth sequence based on a second interleaving pattern, to obtain a sixth sequence; and perform rate matching on the sixth sequence to obtain a second rate matching sequence.

In a possible design, the second interleaving pattern indicates to place a value of an $A^{th}$ bit of the fourth sequence in a $B^{th}$ bit of the sixth sequence through swapping; and a mapping relationship between A and B is: (12, 31), (9, 30), (19, 29), (18, 28), (1, 27), (15, 26), (14, 25), (29, 24), (16, 23), (10, 22), (28, 21), (23, 20), (20, 19), (6, 18), (21, 17), (7, 16), (2, 15), (25, 14), (0, 13), (3, 12), (5, 11), (31, 10), (30, 9), (4, 8), (22, 7), (13, 6), (27, 5), and (8, 4); or a mapping relationship between A and B is: (18, 31), (29, 30), (9, 29), (12, 28), (27, 27), (22, 26), (23, 25), (26, 24), (4, 23), (0, 22), (7, 21), (14, 20), (8, 19), (19, 18), (1, 17), (21, 16), (13, 15), (11, 14), (17, 13), (20, 12), (16, 11), (15, 10), (6, 9), (10, 8), (28, 7), (25, 6), and (24, 5); or a mapping relationship between A and B is: (2, 31), (20, 30), (12, 29), (25, 28), (8, 27), (22, 26), (16, 25), (5, 24), (29, 23), (14, 22), (23, 21), (15, 20), (3, 19), (11, 18), (10, 17), (17, 16), (0, 15), (30, 14), (18, 13), (27, 12), (4, 11), (19, 10), (21, 9), (6, 8), (26, 7), and (9, 6); or a mapping relationship between A and B is: (19, 31), (23, 30), (16, 29), (18, 28), (29, 27), (0, 26), (21, 25), (8, 24), (11, 23), (4, 22), (13, 21), (2, 20), (20, 19), (24, 18), (25, 17), (6, 16), (28, 15), (14, 14), (10, 13), (9, 12), (31, 11), (26, 10), (7, 9), (17, 8), and (1, 7); or a mapping relationship between A and B is: (7, 31), (9, 30), (19, 29), (26, 28), (31, 27), (21, 26), (27, 25), (2, 24), (23, 23), (17, 22), (10, 21), (30, 20), (25, 19), (24, 18), (0, 17), (16, 16), (4, 15), (11, 14), (20, 13), (12, 12), (29, 11), (18, 10), (13, 9), and (3, 8); or a mapping relationship between A and B is: (15, 31), (16, 30), (9, 29), (14, 28), (17, 27), (24, 26), (21, 25), (20, 24), (5, 23), (1, 22), (7, 21), (30, 20), (11, 19), (6, 18), (2, 17), (3, 16), (8, 15), (22, 14), (12, 13), (23, 12), (19, 11), (10, 10), and (29, 9); or a mapping relationship between A and B is: (17, 31), (21, 30), (15, 29), (14, 28), (4, 27), (24, 26), (8, 25), (29, 24), (19, 23), (16, 22), (7, 21), (2, 20), (9, 19), (25, 18), (26, 17), (23, 16), (28, 15), (30, 14), (13, 13), (6, 12), (22, 11), and (0, 10); or a mapping relationship between A and B is: (28, 31), (29, 30), (14, 29), (26, 28), (8, 27), (23, 26), (24, 25), (30, 24), (0, 23), (31, 22), (10, 21), (5, 20), (20, 19), (4, 18), (16, 17), (12, 16), (9, 15), (21, 14), (1, 13), (11, 12), and (22, 11); or a mapping relationship between A and B is: (22, 31), (19, 30), (28, 29), (9, 28), (4, 27), (6, 26), (14, 25), (11, 24), (3, 23), (13, 22), (0, 21), (15, 20), (26, 19), (24, 18), (27, 17), (18, 16), (21, 15), (17, 14), (20, 13), and (12, 12).

In a possible design, the second interleaving pattern indicates to place a value of an $A^{th}$ bit of the fourth sequence in a $B^{th}$ bit of the sixth sequence through swapping; and a mapping relationship between A and B is: (5, 31), (11, 30), (24, 29), (30, 28), (13, 27), (20, 26), (22, 25), (3, 24), (4, 23), (25, 22), (31, 21), (6, 20), (10, 19), (8, 18), (21, 17), (15, 16), (9, 15), (2, 14), (0, 13), (27, 12), (14, 11), (16, 10), (17, 9), (23, 8), (28, 7), (26, 6), (1, 5), and (7, 4); or a mapping relationship between A and B is: (16, 31), (28, 30), (10, 29), (30, 28), (19, 27), (7, 26), (13, 25), (9, 24), (11, 23), (6, 22), (8, 21), (26, 20), (21, 19), (20, 18), (23, 17), (25, 16), (0, 15), (17, 14), (27, 13), (22, 12), (18, 11), (15, 10), (5, 9), (12, 8), (2, 7), (29, 6), and (24, 5); or a mapping relationship between A and B is: (9, 31), (19, 30), (11, 29), (12, 28), (21, 27), (0, 26), (29, 25), (2, 24), (4, 23), (31, 22), (10, 21), (1, 20), (22, 19), (7, 18), (24, 17), (30, 16), (20, 15), (3, 14), (28, 13), (13, 12), (14, 11), (8, 10), (6, 9), (5, 8), (17, 7), and (18, 6); or a mapping relationship between A and B is: (11, 31), (25, 30), (31, 29), (27, 28), (14, 27), (0, 26), (22, 25), (19, 24), (18, 23), (3, 22), (20, 21), (2, 20), (4, 19), (17, 18), (23, 17), (24, 16), (12, 15), (1, 14), (7, 13), (10, 12), (28, 11), (26, 10), (6, 9), (5, 8), and (8, 7); or a mapping relationship between A and B is: (7, 31), (12, 30), (2, 29), (5, 28), (26, 27), (6, 26), (27, 25), (24, 24), (4, 23), (19, 22), (1, 21), (29, 20), (9, 19), (8, 18), (13, 17), (11, 16), (28, 15), (10, 14), (25, 13), (16, 12), (30, 11), (0, 10), (21, 9), and (3, 8); or a mapping relationship between A and B is: (7, 31), (30, 30), (17, 29), (16, 28), (19, 27), (6, 26), (29, 25), (18, 24), (10, 23), (3, 22), (24, 21), (9, 20), (21, 19), (28, 18), (31, 17), (12, 16), (23, 15), (2, 14), (15, 13), (4, 12), (27, 11), (20, 10), and (25, 9); or a mapping relationship between A and B is: (28, 31), (25, 30), (17, 29), (6, 28), (11, 27), (21, 26), (27, 25), (30, 24), (3, 23), (1, 22), (4, 21), (8, 20), (15, 19), (26, 18), (29, 17), (18, 16), (9, 15), (19, 14), (2, 13), (20, 12), (23, 11), and (10, 10); or a mapping relationship between A and B is: (23, 31), (30, 30), (3, 29), (28, 28), (14, 27), (19, 26), (9, 25), (16, 24), (29, 23), (13, 22), (26, 21), (12, 20), (18, 19), (0, 18), (15, 17), (4, 16), (20, 15), (1, 14), (25, 13), (31, 12), and (21, 11); or a mapping relationship between A and B is: (1, 31), (24, 30), (14, 29), (15, 28), (25, 27), (12, 26), (26, 25), (13, 24), (27, 23), (31, 22), (8, 21), (5, 20), (20, 19), (21, 18), (3, 17), (28, 16), (17, 15), (6, 14), (19, 13), and (11, 12).

For technical effect brought by any one of the second aspect or the possible designs of the second aspect, refer to the technical effect brought by any one of the first aspect or the possible designs of the first aspect. Details are not described again.

According to a third aspect, an embodiment of this application provides a communication apparatus. The communication apparatus includes one or more processors. The one or more processors are configured to run a computer program or instructions. When the one or more processors execute computer instructions or the instructions, the communication apparatus is enabled to perform the polar code encoding method according to any one of the first aspect or the possible designs of the first aspect.

In a possible design, the communication apparatus further includes one or more memories, the one or more memories are coupled to the one or more processors, and the one or more memories are configured to store the foregoing computer program or instructions. In a possible implementation, the memory is located outside the communication apparatus. In another possible implementation, the memory is located inside the communication apparatus. In this embodiment of this application, the processor and the memory may alternatively be integrated into one component. In other words, the processor and the memory may alternatively be integrated together. In a possible implementation, the communication apparatus further includes a transceiver. The transceiver is configured to receive information and/or send information.

In a possible design, the communication apparatus further includes one or more communication interfaces, the one or more communication interfaces are coupled to the one or more processors, and the one or more communication interfaces are configured to communicate with a module other than the communication apparatus.

According to a fourth aspect, an embodiment of this application provides a communication apparatus. The communication apparatus includes an input/output interface and a logic circuit. The input/output interface is configured to input and/or output information. The logic circuit is configured to perform the polar code encoding method according to any one of the first aspect or the possible designs of the first aspect, and perform processing based on information and/or generate information.

According to a fifth aspect, an embodiment of this application provides a computer-readable storage medium. The computer-readable storage medium stores computer instructions or a program. When the computer instructions or the program is run on a computer, the polar code encoding method according to any one of the first aspect or the possible designs of the first aspect is performed.

According to a sixth aspect, an embodiment of this application provides a computer program product including computer instructions. When the computer program product is run on a computer, the polar code encoding method according to any one of the first aspect or the possible designs of the first aspect is performed.

According to a seventh aspect, an embodiment of this application provides a computer program. When the computer program is run on a computer, the polar code encoding method according to any one of the first aspect or the possible designs of the first aspect is performed.

According to an eighth aspect, an embodiment of this application provides a chip, including a processor. The processor is coupled to a memory, the memory is configured to store a program or instructions. When the program or the instructions are executed by the processor, the chip is enabled to perform the polar code encoding method according to any one of the first aspect or the possible designs of the first aspect.

For technical effect brought by any one of the design manners of the third aspect to the eighth aspect, refer to the technical effect brought by any one of the first aspect or the possible designs of the first aspect. Details are not described again.

According to a ninth aspect, an embodiment of this application provides a communication system. The communication system may include the communication apparatus according to any one of the second aspect or the possible designs of the second aspect.

## BRIEF DESCRIPTION OF DRAWINGS

FIG. 1 is a diagram of a decoding procedure of an LTE-RM code according to an embodiment of this application;
FIG. 2 is a diagram of a PC-Polar code according to an embodiment of this application;
FIG. 3 is a diagram of comparison between decoding complexity of an LTE-RM code and a PC-Polar code according to an embodiment of this application;
FIG. 4 is a diagram of a communication system according to an embodiment of this application;
FIG. 5 is a diagram of encoding and decoding performed by a transmit end device and a receive end device according to an embodiment of this application;
FIG. 6 is a diagram of composition of a communication apparatus according to an embodiment of this application;
FIG. 7 is a flowchart of a polar code encoding method according to an embodiment of this application;
FIG. 8 is a diagram of a first matrix according to an embodiment of this application;
FIG. 9 is a diagram of a first matrix according to an embodiment of this application;
FIG. 10 is a diagram of a search process of a first interleaving pattern according to an embodiment of this application;
FIG. 11 is a diagram of a first interleaving pattern according to an embodiment of this application;
FIG. 12 is a diagram of a first interleaving pattern according to an embodiment of this application;
FIG. 13 is a diagram of a second interleaving pattern according to an embodiment of this application;
FIG. 14 is a diagram of a second interleaving pattern according to an embodiment of this application;
FIG. 15 is a diagram of performance comparison according to an embodiment of this application;
FIG. 16 is a diagram of performance comparison according to an embodiment of this application;
FIG. 17 is a diagram of performance comparison according to an embodiment of this application;
FIG. 18 is a diagram of performance comparison according to an embodiment of this application;
FIG. 19 is a diagram of performance comparison according to an embodiment of this application;
FIG. 20 is a diagram of a communication apparatus according to an embodiment of this application; and
FIG. 21 is a diagram of composition of a communication apparatus according to an embodiment of this application.

## DESCRIPTION OF EMBODIMENTS

Before embodiments of this application are described, technical terms used in embodiments of this application are described.

**Long term evolution-Reed-Muller (long term evolution-reed-muller, LTE-RM) code encoding:** A transmit end device may encode a very short information bit sequence of 3 to 11 bits in the following manner:
Step 1: Encode an information bit sequence $c_0$, $c_1$, $\cdots$ , and $c_{K-1}$ whose length is K, to obtain an encoded sequence $d_0$, $d_1$,

···, and $d_{N-1}$ whose length is N.

For example, K may be any value in 3 to 11, and N may be 32. $d_i = \left(\sum_{k=0}^{K-1} c_k M_{i,k}\right)$, a value of $M_{i,k}$ may be determined according to Table 1 below, and i=0, 1, 2, ..., and N-1.

Table 1

| i | $M_{i,0}$ | $M_{i,1}$ | $M_{i,2}$ | $M_{i,3}$ | $M_{i,4}$ | $M_{i,5}$ | $M_{i,6}$ | $M_{i,7}$ | $M_{i,8}$ | $M_{i,9}$ | $M_{i,10}$ |
|---|---|---|---|---|---|---|---|---|---|---|---|
| 0 | 1 | 1 | 0 | 0 | 0 | 0 | 0 | 0 | 0 | 0 | 1 |
| 1 | 1 | 1 | 1 | 0 | 0 | 0 | 0 | 0 | 0 | 1 | 1 |
| 2 | 1 | 0 | 0 | 1 | 0 | 0 | 1 | 0 | 1 | 1 | 1 |
| 3 | 1 | 0 | 1 | 1 | 0 | 0 | 0 | 0 | 1 | 0 | 1 |
| 4 | 1 | 1 | 1 | 1 | 0 | 0 | 0 | 1 | 0 | 0 | 1 |
| 5 | 1 | 1 | 0 | 0 | 1 | 0 | 1 | 1 | 1 | 0 | 1 |
| 6 | 1 | 0 | 1 | 0 | 1 | 0 | 1 | 0 | 1 | 1 | 1 |
| 7 | 1 | 0 | 0 | 1 | 1 | 0 | 0 | 1 | 1 | 0 | 1 |
| 8 | 1 | 1 | 0 | 1 | 1 | 0 | 0 | 1 | 0 | 1 | 1 |
| 9 | 1 | 0 | 1 | 1 | 1 | 0 | 1 | 0 | 0 | 1 | 1 |
| 10 | 1 | 0 | 1 | 0 | 0 | 1 | 1 | 1 | 0 | 1 | 1 |
| 11 | 1 | 1 | 1 | 0 | 0 | 1 | 1 | 0 | 1 | 0 | 1 |
| 12 | 1 | 0 | 0 | 1 | 0 | 1 | 0 | 1 | 1 | 1 | 1 |
| 13 | 1 | 1 | 0 | 1 | 0 | 1 | 0 | 1 | 0 | 1 | 1 |
| 14 | 1 | 0 | 0 | 0 | 1 | 1 | 0 | 1 | 0 | 0 | 1 |
| 15 | 1 | 1 | 0 | 0 | 1 | 1 | 1 | 1 | 0 | 1 | 1 |
| 16 | 1 | 1 | 1 | 0 | 1 | 1 | 1 | 0 | 0 | 1 | 0 |
| 17 | 1 | 0 | 0 | 1 | 1 | 1 | 0 | 0 | 1 | 0 | 0 |
| 18 | 1 | 1 | 0 | 1 | 1 | 1 | 1 | 1 | 0 | 0 | 0 |
| 19 | 1 | 0 | 0 | 0 | 0 | 1 | 1 | 0 | 0 | 0 | 0 |
| 20 | 1 | 0 | 1 | 0 | 0 | 0 | 1 | 0 | 0 | 0 | 1 |
| 21 | 1 | 1 | 0 | 1 | 0 | 0 | 0 | 0 | 0 | 1 | 1 |
| 22 | 1 | 0 | 0 | 0 | 1 | 0 | 0 | 1 | 1 | 0 | 1 |
| 23 | 1 | 1 | 1 | 0 | 1 | 0 | 0 | 0 | 1 | 1 | 1 |
| 24 | 1 | 1 | 1 | 1 | 1 | 0 | 1 | 1 | 1 | 1 | 0 |
| 25 | 1 | 1 | 0 | 0 | 0 | 1 | 1 | 1 | 0 | 0 | 1 |
| 26 | 1 | 0 | 1 | 1 | 0 | 1 | 0 | 0 | 1 | 1 | 0 |
| 27 | 1 | 1 | 1 | 1 | 0 | 1 | 0 | 1 | 1 | 1 | 0 |
| 28 | 1 | 0 | 1 | 0 | 1 | 1 | 1 | 0 | 1 | 0 | 0 |
| 29 | 1 | 0 | 1 | 1 | 1 | 1 | 1 | 1 | 1 | 0 | 0 |
| 30 | 1 | 1 | 1 | 1 | 1 | 1 | 1 | 1 | 1 | 1 | 1 |
| 31 | 1 | 0 | 0 | 0 | 0 | 0 | 0 | 0 | 0 | 0 | 0 |

Step 2: Perform rate matching on the encoded sequence $d_0$, $d_1$, ···, and $d_{N-1}$ whose length is N, to obtain a rate matching sequence $f_0$, $f_1$, ···, and $f_{E-1}$ whose length is E.

E is an actual transmit code length obtained by performing rate matching, or E is described as a transmission code length obtained by performing rate matching. The transmission code length E may be determined based on rate matching related information.

When it is determined that the transmission code length E is not equal to the encoded length N (for example, E is not equal to 32), the following rate matching manner may be used: When the transmission code length E is less than N (for example, E is less than 32), puncturing is performed from back to front; or when the transmission code length E is greater than N (for example, E is greater than 32), repetition is performed from front to back.

For example, the rate matching sequence $f_0$, $f_1$, $\cdots$, and $f_{E-1}$ may be obtained in the following manner:

$$\text{for } j=0 \text{ to } E-1$$

$$f_j = d_{j \bmod N};$$

$$\text{end for}$$

Step 3: Send the rate matching sequence $f_0$, $f_1$, $\cdots$, and $f_{E-1}$.

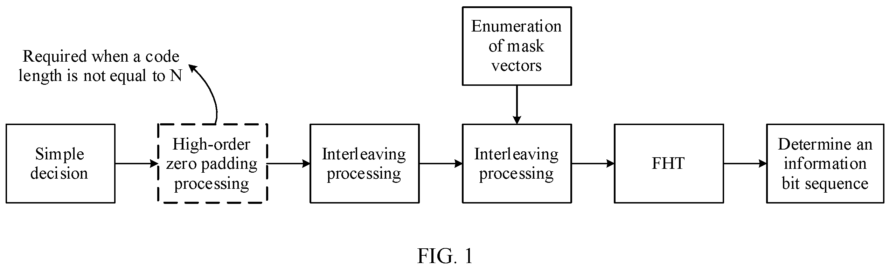

**LTE-RM decoding:** With reference to a diagram of a decoding procedure shown in FIG. 1, a receive end device may decode an encoding result of the very short information bit sequence of 3 to 11 bits in the following manner:
Step 1: Perform simple decision (for example, hard decision) on a received sequence, and perform interleaving processing on a codeword (for example, a bipolar codeword) or soft bit information obtained through simple decision, to obtain a processed receive codeword.

The received sequence may be the rate matching sequence.

Optionally, if a length of the codeword obtained through simple decision is not equal to N, high-order zero padding processing may be performed.

For example, if the codeword obtained through simple decision is $b_0$, $b_1$, $\cdots$, and $b_{19}$ whose length is 20, 12 0s may be padded in high-order bits to obtain a codeword 0, $\cdots$, 0, $b_0$, $b_1$, $\cdots$, and $b_{19}$ whose length is N=32.

Step 2: Perform, based on a mask vector, interleaving processing on the receive codeword processed in Step 1.

The interleaving processing process is the same as the interleaving processing process in Step 1.

For example, 128 mask vectors may be generated according to seven basic mask sequences, and the 128 mask vectors are respectively multiplied by the receive codeword processed in Step 1 (that is, demasking is performed), to obtain 128 bipolar sequences with a length of 32.

Step 3: Perform fast Hadamard transform (fast Hadamard transform, FHT) on the bipolar sequence obtained in Step 2 and a 32-order Hadamard (Hadamard) matrix, to obtain a 128×32 correlation value matrix.

Step 4: Find a maximum absolute value from the correlation value matrix obtained in Step 3, so that a binary format corresponding to a row number with the maximum absolute value is $2^{nd}$ to $6^{th}$ bits of the information bit sequence, and a binary format corresponding to a column number with the maximum absolute value is $7^{th}$ to $13^{th}$ bits of the information bit sequence.

Step 5: A $1^{st}$ bit of the information bit sequence is determined based on an actual sign of the maximum absolute value. That is, when the sign is positive, the $1^{st}$ bit is decoded as 0; and when the sign is negative, the $1^{st}$ bit is decoded as 1.

The $1^{st}$ bit to the $12^{th}$ bit in Step 4 and Step 5 define the information bit sequence starting from the $1^{st}$ bit. It may be understood that the information bit sequence may alternatively be defined starting from the $0^{th}$ bit, that is, the $1^{st}$ bit, the $2^{nd}$ bit, ..., and the $12^{th}$ bit are respectively replaced with the $0^{th}$ bit, the $1^{st}$ bit, ..., and the $11^{th}$ bit. This is not limited.

However, the LTE-RM decoding uses the FHT. When the length of the information bit sequence is greater than 6 bits, the mask vectors need to be enumerated and demasking (demask) needs to be performed, resulting in high complexity and high power consumption for the LTE-RM decoding scheme to achieve maximum likelihood (maximum likelihood, ML) decoding performance. In addition, when the length E of the rate matching sequence is small, there is a large quantity of punctures, leading to performance bad points, and affecting decoding performance.

**Parity-check polar code (parity check polar codes, PC-Polar codes):** The PC-Polar code may include an information bit position, a frozen bit position, a PC bit position, and a rate matching shortened bit position. The information bit position may be used to carry an information bit, the frozen bit position may be used to carry a frozen bit, the PC bit position may be used to carry a PC bit, and the rate matching shortened bit position does not need to be sent to a channel.

A part of sets may be selected from the frozen bit positions as PC bit positions. Values of PC bits in these PC bit positions are different from those in other frozen bit positions, and are not fixed to 0, but are determined by using a PC equation based on values of information bits of information bit positions before the PC bit positions. Therefore, the PC bit positions may also be referred to as dynamic frozen bit positions (that is, the positions are from the frozen bit positions, but the values are not fixed to 0).

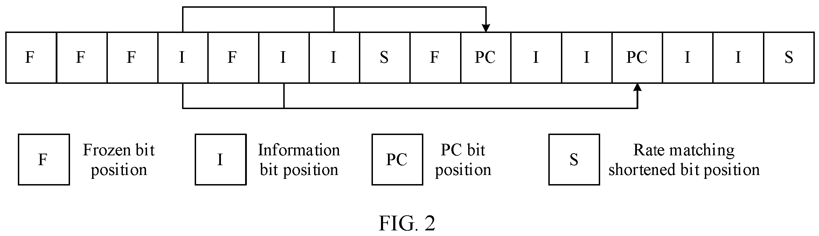

For example, the length of the information bit sequence is 7. The PC-Polar code corresponding to the information bit sequence may be a PC-Polar code shown in FIG. 2. The frozen bit positions may be $0^{th}$, $1^{st}$, $2^{nd}$ $4^{th}$, and $8^{th}$ bits, the information bit positions may be $3^{rd}$, $5^{th}$ $6^{th}$, $10^{th}$ $11^{th}$, $13^{th}$, and $14^{th}$ bits, the PC bit positions may be $9^{th}$ and $12^{th}$ bits, and the rate matching shortened bit positions may be $7^{th}$ and $15^{th}$ bits.

A value of the PC bit at the 9th bit may be an exclusive OR of a value of an information bit at the 3rd bit and a value of an information bit at the 6th bit, and a value of the PC bit at the 12th bit may be an exclusive OR of a value of an information bit at the 3rd bit and a value of an information bit at the 5th bit.

Based on the foregoing description, compared with the LTE-RM encoding and decoding scheme, using the PC-Polar code for encoding and decoding can reduce decoding complexity, reduce power consumption, and improve decoding performance.

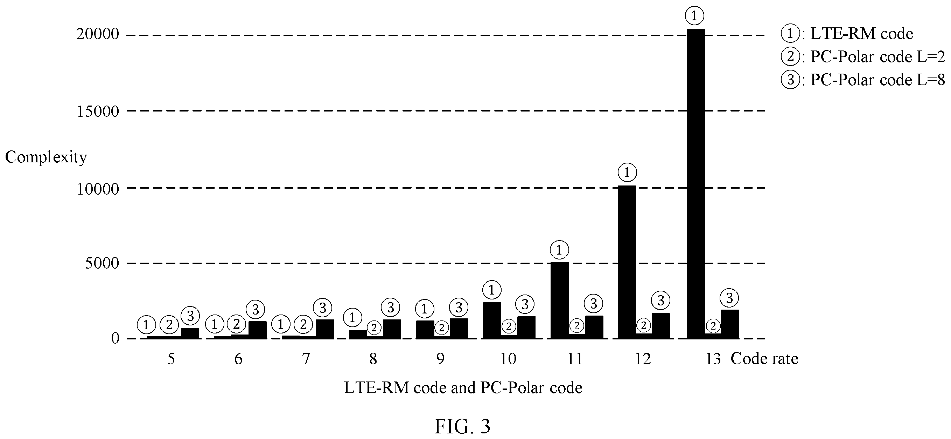

For example, as shown in FIG. 3, it can be learned that for different code rates, decoding complexity of a PC-Polar code is less than decoding complexity of an LTE-RM code.

However, in the PC-Polar code, for information bit sequences of different lengths (or described as different quantities of information bits), positions of information bits of the sequences are different, leading to different PC bit positions and PC equations (for example, a PC bit position corresponding to an information bit sequence whose length is 4 may not be a PC bit position in an information bit sequence whose length is 3, and corresponding PC equations are also different). Consequently, corresponding PC bit positions and PC equations need to be separately stored for the information bit sequences of different lengths, hardware complexity is higher, and hardware overheads are higher.

To resolve this technical problem, an embodiment of this application provides a polar code encoding method. In the method, a transmit end device may map, based on a reliability sequence, an information bit sequence whose length is k to k bits of a first sequence whose length is N, to obtain a second sequence; multiply the second sequence by a first matrix to obtain a third sequence; and perform polar encoding on the third sequence to obtain a fourth sequence, where a length of the reliability sequence is N, the second sequence includes k information bit positions, x parity check PC bit positions, and N-k-x frozen bit positions, $k \leq K \leq N$, $1 \leq x$, K is a maximum value of the length of the information bit sequence, k, K, N, and x are all positive integers, the first matrix is a matrix with all 0s below a diagonal and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 in the first matrix is less than or equal to N-K.

In this embodiment of this application, a reliability sequence whose length is N can be separately constructed for the information bit sequence. In this way, when puncturing is performed in a back-to-front order, a quantity of performance bad points is reduced, code spectrum characteristics are improved, and decoding performance is improved. In addition, in this embodiment of this application, polar codes can be constructed based on a same first matrix for sequences of different quantities of information bits, that is, PC bit positions and PC equations corresponding to the sequences of different quantities of information bits are nested, and there is no need to separately store corresponding PC bit positions and PC equations for the information bit sequences of different lengths, thereby reducing hardware complexity, reducing hardware overheads, improving code spectrum characteristics, reducing decoding complexity, and improving decoding performance.

The following describes implementations of embodiments of this application in detail with reference to accompanying drawings in this specification.

The polar code encoding method provided in embodiments of this application may be applied to any communication system. The communication system may be a 3rd generation partnership project (third generation partnership project, 3GPP) communication system, for example, a long term evolution (long term evolution, LTE) system, or may be a 5th generation (fifth generation, 5G) mobile communication system, a system with hybrid networking of LTE and 5G, a new radio (new radio, NR) system, an NR vehicle-to-everything (vehicle-to-everything, V2X) system, a device-to-device (device-to-device, D2D) communication system, a machine-to-machine (machine-to-machine, M2M) communication system, internet of things (internet of things, IoT), a narrowband internet of things (narrowband-internet of things, NB-IoT) system, a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronous code division multiple access (time division-synchronous code division multiple access, TD-SCDMA) system, enhanced mobile broadband (enhanced mobile broadband, eMBB), ultra-reliable and low-latency communication (ultra-reliable and low-latency communication, URLLC), enhanced machine-type communication (enhanced machine-type communication, eMTC), and various types of next-generation communication systems, like a 6th generation (sixth generation, 6G) mobile communication system, or may be a non-terrestrial network (non-terrestrial network, NTN) system, a non-3GPP communication system, or the like. This is not limited.

The polar code encoding method provided in embodiments of this application may be applied to various communication scenarios, and is particularly applicable to a channel coding scenario in which a polar code is used as a short code in a communication system. For example, the polar code encoding method may be applied to one or more of the following communication scenarios: control channel coding, data channel coding, and the like. This is not limited.

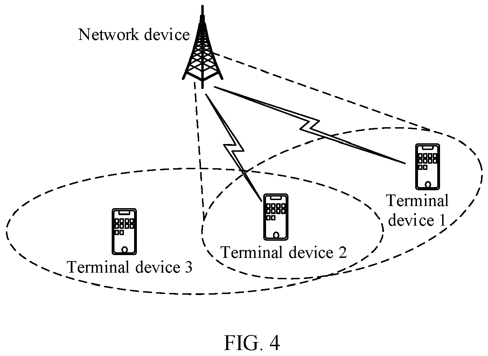

The following uses FIG. 4 as an example to describe the communication system provided in embodiments of this application.

FIG. 4 is a diagram of a communication system according to an embodiment of this application. As shown in FIG.

4, the communication system may include at least one terminal device and at least one network device.

In FIG. 4, the terminal device may be located in beam/cell coverage of the network device, and the network device may provide a communication service for the terminal device. For example, the network device may encode downlink data through channel coding, and transmit the downlink data to the terminal device through an air interface after constellation modulation (that is, the network device is a transmit end device, and the terminal device is a receive end device). Alternatively, the terminal device may encode uplink data through channel coding, and send the uplink data to the network device through an air interface after constellation modulation (that is, the terminal device is a transmit end device, and the network device is a receive end device). It may be understood that, when the network device communicates with the network device, or the terminal device communicates with the terminal device, communication may be performed through channel coding. In other words, both the transmit end device and the receive end device may be network devices, or both may be terminal devices. This is not limited.

The terminal device in FIG. 4 may be a device having a wireless transceiver function or a chip or a chip system that can be disposed in the device, may allow a user to access a network, and is a device configured to provide voice and/or data connectivity for the user. The terminal device may also be referred to as user equipment (user equipment, UE), a subscriber unit (subscriber unit), a terminal (terminal), a mobile station (mobile station, MS), a mobile terminal (mobile terminal, MT), or the like.

For example, the terminal device in FIG. 4 may be a mobile phone (mobile phone), a tablet computer, or a computer with a wireless transceiver function. Alternatively, the terminal device may be a user station, a mobile station, a remote station, a remote terminal device, a mobile terminal device, a user terminal device, a wireless communication device, a user agent, a user apparatus, a cellular phone, a cordless phone, a session initiation protocol (session initiation protocol, SIP) phone, a wireless local loop (wireless local loop, WLL) station, a personal digital processing (personal digital assistant, PDA), a handheld device having a wireless communication function, a computing device, a processing device connected to a wireless modem, a vehicle-mounted device, a wearable device, a terminal device in the internet of things, household appliance, a virtual reality (virtual reality, VR) terminal, an augmented reality (augmented reality, AR) terminal, a wireless terminal in industrial control, a wireless terminal in self-driving, a wireless terminal in telemedicine, a wireless terminal in a smart grid, a wireless terminal in a smart city (smart city), a wireless terminal in a smart home (smart home), a vehicle having a vehicle-to-vehicle (vehicle-to-vehicle, V2V) communication capability, an intelligent connected vehicle, an uncrewed aerial vehicle having an uncrewed aerial vehicle to uncrewed aerial vehicle (UAV to UAV, U2U) communication capability, a terminal device in a future network, a terminal device in a future evolved public land mobile network (public land mobile network, PLMN), or the like. This is not limited.

The network device in FIG. 4 may be any device that is deployed in an access network and that can perform wireless communication with a terminal device, or may be a chip or a chip system that can be disposed in the device, or may be a logical node or a logical module or a function implemented by software, and may be configured to implement functions such as a radio physical control function, resource scheduling and radio resource management, radio access control, and mobility management. Specifically, the network device may be a device supporting wired access, or may be a device supporting wireless access.

For example, the network device may include one or more access network (access network, AN) or radio access network (radio access network, RAN) nodes. The AN/RAN node may be a continuously evolved NodeB (gNB), a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB or a home NodeB, HNB), a baseband unit (baseband unit, BBU), a wireless fidelity (wireless fidelity, Wi-Fi) access point (access point, AP), or the like.

In another example, the network device may include a baseband unit (baseband unit, BBU) and a remote radio unit (remote radio unit, RRU). The BBU and the RRU may be placed at different places. For example, the RRU is remote and placed in a heavy-traffic area, and the BBU is placed in a central equipment room. Alternatively, the BBU and the RRU may be placed in a same equipment room. Alternatively, the BBU and the RRU may be different components at a same rack.

In still another example, the network device may alternatively be a device including a central unit (central unit, CU) node, including a distributed unit (distributed unit, DU) node, or including a CU node and a DU node. For example, the network device may be divided into a CU and a DU from a perspective of logical functions. Some protocol layer functions are centrally controlled by the CU, and a part or all of the remaining protocol layer functions are distributed in the DU, and the CU centrally controls the DU. Further, the central unit CU may be further divided into a control plane (CU-CP) and a user plane (CU-UP). In different systems, a CU (including a CU-CP or a CU-UP) or a DU may have different names. For example, in an open radio access network (open radio access network, O-RAN) system, the CU may also be referred to as an O-CU (open CU), the DU may also be referred to as an O-DU, the CU-CP may also be referred to as an O-CU-CP, and the CU-UP may also be referred to as an O-CU-UP.

Based on the foregoing descriptions of the terminal device and the network device, optionally, the polar code encoding method provided in embodiments of this application may be implemented by the terminal device or the network device, or may be implemented by a component of the terminal device or the network device, for example, implemented by an application-specific integrated circuit (application-specific integrated circuit, ASIC), a field programmable gate array (field programmable gate array, FPGA), or software (for example, program code in a memory) deployed in the terminal device or the network device. This is not limited.

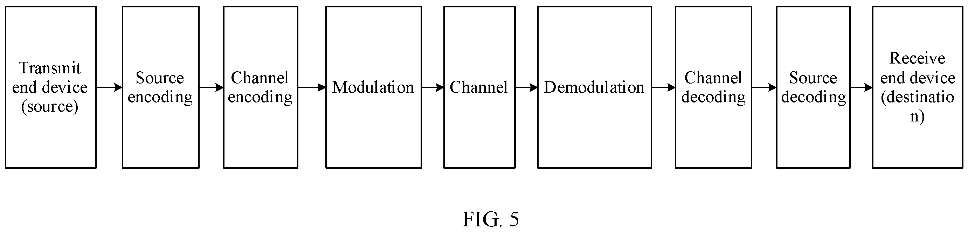

Optionally, in embodiments of this application, the transmit end device (or referred to as a source) and the receive end device (or referred to as a destination) may perform encoding and decoding by using a procedure shown in FIG. 5.

The transmit end device may perform source encoding on bits generated by the transmit end device, to obtain a source bit stream, perform channel encoding on the source bit stream via channel coding, and then send a modulation symbol to the receive end device through a noisy channel after modulation. When receiving the modulation symbol through the noisy channel, the receive end device may perform demodulation, then perform channel decoding to restore the source bit stream, and then perform source decoding to obtain a decoding result.

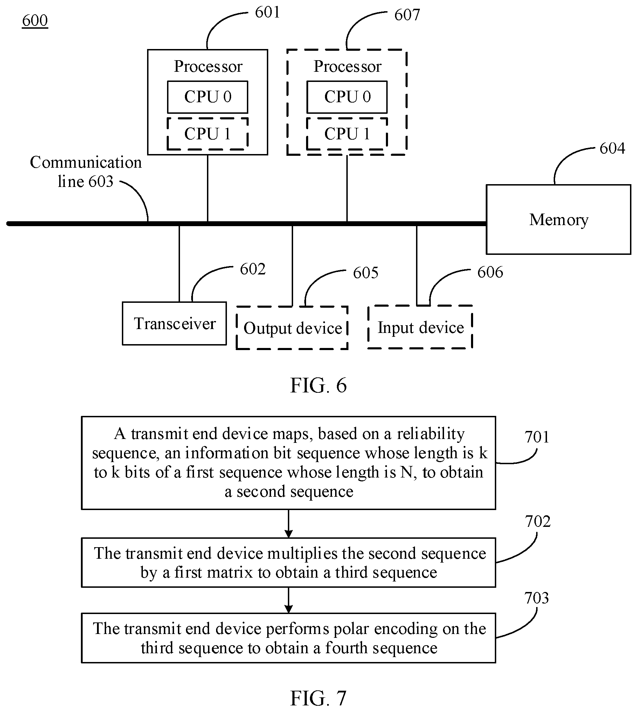

During specific implementation, as shown in FIG. 4, for example, each terminal device or each network device may use a composition structure shown in FIG. 6, or include components shown in FIG. 6. FIG. 6 is a diagram of composition of a communication apparatus 600 according to an embodiment of this application. The communication apparatus 600 may be a terminal device, or a chip or a system on chip in the terminal device, or may be a network device, or a chip or a system on chip in the network device. As shown in FIG. 6, the communication apparatus 600 includes a processor 601, a transceiver 602, and a communication line 603.

Further, the communication apparatus 600 may further include a memory 604. The processor 601, the memory 604, and the transceiver 602 may be connected through the communication line 603.

The processor 601 is a central processing unit (central processing unit, CPU), a general-purpose processor network processor (network processor, NP), a digital signal processor (digital signal processing, DSP), a microprocessor, a microcontroller, a programmable logic device (programmable logic device, PLD), or any combination thereof. The processor 601 may alternatively be another apparatus having a processing function, for example, a circuit, a component, or a software module. This is not limited.

The transceiver 602 is configured to communicate with another device or another communication network. The another communication network may be an Ethernet, a radio access network (radio access network, RAN), a wireless local area network (wireless local area network, WLAN), or the like. The transceiver 602 may be a module, a circuit, a transceiver, or any apparatus that can implement communication.

The communication line 603 is configured to transmit information between components included in the communication apparatus 600.

The memory 604 is configured to store instructions. The instructions may be computer programs.

The memory 604 may be a read-only memory (read-only memory, ROM) or another type of static storage device that can store static information and/or instructions, or may be a random access memory (random access memory, RAM) or another type of dynamic storage device that can store information and/or instructions, or may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, and the like), a disk storage medium or another magnetic storage device, or the like. This is not limited.

It should be noted that, the memory 604 may exist independently of the processor 601, or may be integrated with the processor 601. The memory 604 may be configured to store instructions, program code, some data, or the like. The memory 604 may be located in the communication apparatus 600, or may be located outside the communication apparatus 600. This is not limited. The processor 601 is configured to execute the instructions stored in the memory 604, to implement the polar code encoding method provided in the following embodiments of this application.

In an example, the processor 601 may include one or more CPUs, for example, a CPU 0 and a CPU 1 in FIG. 6.

In an optional implementation, the communication apparatus 600 includes a plurality of processors. For example, in addition to the processor 601 in FIG. 6, the communication apparatus 600 may further include a processor 607.

In an optional implementation, the communication apparatus 600 further includes an output device 605 and an input device 606. For example, the input device 606 is a device such as a keyboard, a mouse, a microphone, or a joystick, and the output device 605 is a device such as a display or a speaker (speaker).

It should be noted that the communication apparatus 600 may be a desktop computer, a portable computer, a network server, a mobile phone, a tablet computer, a wireless terminal, an embedded device, a chip system, or a device having a similar structure in FIG. 6. In addition, the composition structure shown in FIG. 6 does not constitute a limitation on the communication apparatus. In addition to the components shown in FIG. 6, the communication apparatus may include more or fewer components than those shown in the figure, or combine some components, or have different component arrangements.

In this embodiment of this application, the chip system may include a chip, or may include a chip and another discrete component.

In addition, actions, terms, and the like in embodiments of this application may be mutually referenced. This is not limited. In embodiments of this application, names of messages exchanged between devices, names of parameters in the messages, or the like are merely examples. Other names may alternatively be used during specific implementation. This is not limited.

With reference to the communication system shown in FIG. 4, the following describes a polar code encoding method provided in an embodiment of this application with reference to FIG. 7. The transmit end device may be any terminal device or network device in the communication system shown in FIG. 4, and the receive end device may also be any terminal device or network device in the communication system shown in FIG. 4. The transmit end device or the receive end device described in the following embodiment may have the components shown in FIG. 6.

FIG. 7 is a flowchart of a polar code encoding method according to an embodiment of this application. As shown in FIG. 7, the method may include the following steps.

Step 701: A transmit end device maps, based on a reliability sequence, an information bit sequence whose length is k to k bits of a first sequence whose length is N, to obtain a second sequence.

The reliability sequence may indicate reliability corresponding to each bit in the sequence. A larger value of the reliability indicates a more reliable bit corresponding to the reliability. A length of the reliability sequence may be N, and N is a positive integer.

Optionally, N is less than 1024.

Optionally, the reliability sequence may be determined based on one or more of the following: reliability, a code spectrum, and a performance optimization result.

In this embodiment of this application, the reliability sequence whose length is N may be separately constructed for the information bit sequence based on parameters such as the reliability, the code spectrum, and the performance optimization result. When an encoded sequence is subsequently punctured in a back-to-front order, a quantity of performance bad points can be reduced, code spectrum characteristics can be improved, and decoding performance can be improved.

For example, the length N of the reliability sequence is 32, and the reliability sequence may be a reliability sequence shown in Table 2 below, where $W(Q_i^{Nmax})$ represents reliability, and $Q_i^{Nmax}$ represents a bit corresponding to the reliability:

Table 2

| $W(Q_i^{Nmax})$ | $Q_i^{Nmax}$ | $W(Q_i^{Nmax})$ | $\overline{Q_i^{Nmax}}$ | $\overline{W(Q_i^{Nmax})}$ | $\overline{Q_i^{Nmax}}$ | $\overline{W(Q_i^{Nmax})}$ | $\overline{Q_i^{Nmax}}$ | $\overline{W(Q_i^{Nmax})}$ | $Q_i^{Nmax}$ | $\overline{W(Q_i^{Nmax})}$ | $\overline{Q_i^{Nmax}}$ | $\overline{W(Q_i^{Nmax})}$ | $Q_i^{Nmax}$ | $\overline{W(Q_i^{Nmax})}$ | $Q_i^{Nmax}$ |
|---|---|---|---|---|---|---|---|---|---|---|---|---|---|---|---|
| 0 | 0 | 4 | 8 | 8 | 9 | 12 | 18 | 16 | 7 | 20 | 25 | 24 | 13 | 28 | 27 |
| 1 | 1 | 5 | 16 | 9 | 6 | 13 | 12 | 17 | 26 | 21 | 28 | 25 | 22 | 29 | 29 |
| 2 | 2 | 6 | 3 | 10 | 17 | 14 | 20 | 18 | 19 | 22 | 11 | 26 | 15 | 30 | 30 |
| 3 | 4 | 7 | 5 | 11 | 10 | 15 | 24 | 19 | 21 | 23 | 14 | 27 | 23 | 31 | 31 |

It may be understood that Table 2 is defined starting from 0 bits, or may be defined starting from 1 bit, that is, 0, 1, ..., and 31 described above may be respectively replaced with 1, 2, ..., and 32. This is not limited.

Referring to the reliability sequence, the transmit end device may map the information bit sequence whose length is k to the k bits of the first sequence whose length is N, to obtain the second sequence.

k≤K≤N, K is a maximum value of the length of the information bit sequence, and k, K, and N are all positive integers.

For example, the length k of the information bit sequence may be any one of the following values: 3, 4, 5, 6, 7, 8, 9, 10, and 11. In this case, K is equal to 11.

For example, the length N of the first sequence may be 32.

The transmit end device may select the first k bits of the first sequence as information bit positions based on the reliability sequence in descending order of reliability, and sequentially map the information bit sequence whose length is k to the k bits, that is, map the information bit sequence to the k information bit positions of the first sequence, and set values of the remaining N-k bits of the first sequence to 0, to obtain the second sequence.

The second sequence may include k information bit positions, x PC bit positions, and N-k-x frozen bit positions, 1≤x, and x is a positive integer.

Optionally, an example in which the definition starts from 0 bits is used, the information bit sequence may be denoted as $u_0^{k-1}$, and the second sequence may be denoted as $a_0^{N-1}$. It may be understood that the definition may alternatively start from 1 bit, that is, the information bit sequence may be denoted as $u_1^k$, and the second sequence may be denoted as $a_1^N$. This is not limited.

The following describes a process of generating the second sequence by using an example in which the definition starts from 0 bits.

For example, the reliability sequence is the reliability sequence whose length is 32 shown in Table 2, and the length of the first sequence is 32. When the length of the information bit sequence is 3, it may be determined, based on the reliability sequence shown in Table 2, that the first 3 bits in descending order of reliability in the first sequence are {31 30 29}, and it may be determined that the information bit positions are {31 30 29}. The information bit sequence whose length is 3 is mapped to the 3 bits of the first sequence, and values of the remaining 29 bits of the first sequence are set to 0, to obtain the second sequence.

In another example, the reliability sequence is the reliability sequence whose length is 32 shown in Table 2, and the length of the first sequence is 32. When the length of the information bit sequence is 11, it may be determined, based on the reliability sequence shown in Table 2, that the first 11 bits in descending order of reliability in the first sequence are {31 30 29 27 23 15 22 13 14 11 28}, and it may be determined that the information bit positions are {31 30 29 27 23 15 22 13 14 11 28}. The information bit sequence whose length is 11 is mapped to the 11 bits of the first sequence, and values of the remaining 21 bits of the first sequence are set to 0, to obtain the second sequence.

Step 702: The transmit end device multiplies the second sequence by a first matrix to obtain a third sequence.

The first matrix may be a matrix with all 0s below a diagonal and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 in the first matrix is less than or equal to N-K. The first matrix may also be referred to as an upper triangular matrix, a pre-transform (pre-transform) matrix, or the like. The first matrix may also be denoted as $T_{pre}$. This is not limited.

For example, N is 32, and K is 11. The first matrix may be a 32×32 matrix, and the quantity of columns whose column weights are greater than 1 in the first matrix is less than or equal to 21.

Optionally, the first matrix may be a sparse matrix.

Optionally, a column weight of the first matrix may be less than or equal to a first value, thereby ensuring sparseness of the first matrix, and obtaining better code spectrum characteristics.

For example, the first value may be any one of the following values: 4, 5, 6, or 7.

Based on the first matrix, the transmit end device may determine, based on the first matrix, one or more PC bit positions and bits checked by the PC bit positions; and determine a value of the PC bit position in the second sequence based on a value of the bit checked by the PC bit position, to obtain the third sequence. The third sequence may include the one or more PC bit positions.

Optionally, a value of the PC bit position may be an exclusive OR of a value of the bit checked by the PC bit position.

Optionally, an example in which the definition starts from 0 bits is used, and the third sequence may be denoted as $v_0^{N-1}$, and $v_0^{N-1} = a_0^{N-1} T_{pre}$. It may be understood that the definition may alternatively start from 1 bit, that is, the third sequence may be denoted as $v_1^N$, and $v_1^N = a_1^N T_{pre}$. This is not limited.

Optionally, a difference between a number of the PC bit position and a number of the bit checked by the PC bit position may be a prime number. The difference between the number of the PC bit position and the number of the bit checked by the PC bit position is limited to be a prime number. This can greatly reduce search space, and reduce loss of optimality as much as possible while improving code spectrum characteristics.

For example, N is 32, the length k of the information bit sequence is 3 to 11, and the information bit sequence is defined starting from 0 bits. When k=11, information bit positions corresponding to the information bit sequence are {31 30 29 27 23 15 22 13 14 11 28}. When k=10, information bit positions corresponding to the information bit sequence are {31 30 29 27 23 15 22 13 14 11}. When k=9, information bit positions corresponding to the information bit sequence are {31 30 29 27 23 15 22 13 14}. When k=8, information bit positions corresponding to the information bit sequence are {31 30 29 27 23 15 22 13}. When k=7, information bit positions corresponding to the information bit sequence are {31 30 29 27 23 15 22}. When k=6, information bit positions corresponding to the information bit sequence are {31 30 29 27 23 15}. When k=5, information bit positions corresponding to the information bit sequence are {31 30 29 27 23}. When k=4, information bit positions corresponding to the information bit sequence are {31 30 29 27}. When k=3, information bit positions corresponding to the information bit sequence are {31 30 29}.

Because the PC bit position is a frozen bit position, and there is at least one information bit position before the PC bit position, for the information bit sequence with k=11, potential PC bit positions may be the following 10 bits: {12 16 17 18 19 20 21 24 25 26}, and information bit positions that can be checked by the 10 potential PC bit positions are information bit positions shown in Table 3:

Table 3

| PC bit position | Information bit position checked by the PC bit position | Quantity of PC function candidates (PC function candidates num) |
|---|---|---|
| 12 | 11 | 2 |
| 16 | 11 13 14 15 | 16 |
| 17 | 11 13 14 15 | 16 |
| 18 | 11 13 14 15 | 16 |
| 19 | 11 13 14 15 | 16 |
| 20 | 11 13 14 15 | 16 |
| 21 | 11 13 14 15 | 16 |
| 24 | 11 13 14 15 22 23 | 64 |
| 25 | 11 13 14 15 22 23 | 64 |
| 26 | 11 13 14 15 22 23 | 64 |

In Table 3, there are a total of $2 \times (16^6) \times (64^3) = 8.7961 \times 10^{12}$ potential PC functions. If the difference between the number of the PC bit position and the number of the bit checked by the PC bit position is limited to be a prime number, as shown in Table 4, there are a total of $1 \times (2^3) \times (4^4) \times (8^2) = 131072$ potential PC functions. This can greatly reduce search space, and reduce loss of optimality as much as possible while improving code spectrum characteristics.

Table 4

| PC bit position | Information bit position checked by the PC bit position | Quantity of PC function candidates (PC function candidates num) |
|---|---|---|
| 12 | null | 1 |
| 16 | 11 13 | 4 |
| 17 | 14 | 2 |
| 18 | 11 13 15 | 8 |
| 19 | 14 | 2 |
| 20 | 13 15 | 4 |

(continued)

| PC bit position | Information bit position checked by the PC bit position | Quantity of PC function candidates (PC function candidates num) |
|---|---|---|
| 21 | 14 | 2 |
| 24 | 11 13 | 4 |
| 25 | 14 22 | 4 |
| 26 | 13 15 23 | 8 |

Compared with k=11 described above, as shown in Table 5 below, for an information bit sequence with k=10, a PC bit position 28 may be added on a basis of k=11 shown in Table 4; for an information bit sequence with k=9, a PC bit position 11 may be added on a basis of k=10; for an information bit sequence with k=8, a PC bit position 14 may be added on a basis of k=9; for an information bit sequence with k=7, a PC bit position 13 may be added on a basis of k=8; for an information bit sequence with k=6, a PC bit position 22 may be added on a basis of k=7; for an information bit sequence with k=5, a PC bit position 15 may be added on a basis of k=6; for an information bit sequence with k=4, a PC bit position 23 may be added on a basis of k=5; and for an information bit sequence with k=3, a PC bit position 27 may be added on a basis of k=4. This can greatly reduce search space, and reduce loss of optimality as much as possible while improving code spectrum characteristics.

Table 5

| k | PC bit position | Information bit position checked by the PC bit position |
|---|---|---|
| 10 | 28 | 11 15 23 |
| 9 | 11 | null |
| 8 | 14 | null |
| 7 | 13 | null |
| 6 | 22 | 15 |
| 5 | 15 | null |
| 4 | 23 | null |
| 3 | 27 | null |

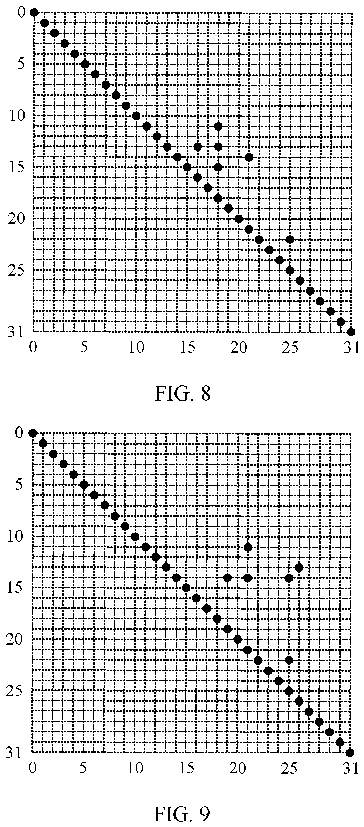

Based on the PC bit position and the information bit position checked by the PC bit position shown in Table 4 and Table 5, in a first possible example, the first matrix may be a $32\times32$ matrix below, and the first matrix may alternatively be represented as a matrix shown in FIG. 8:

$$\begin{bmatrix}
10000000000000000000000000000000\\
01000000000000000000000000000000\\
00100000000000000000000000000000\\
00010000000000000000000000000000\\
00001000000000000000000000000000\\
00000100000000000000000000000000\\
00000010000000000000000000000000\\
00000001000000000000000000000000\\
00000000100000000000000000000000\\
00000000010000000000000000000000\\
00000000001000000000000000000000\\
00000000000100000100000000000000\\
00000000000010000000000000000000\\
00000000000001001010000000000000\\
00000000000000100000010000000000\\
00000000000000010010000000000000\\
00000000000000001000000000000000\\
00000000000000000100000000000000\\
00000000000000000010000000000000\\
00000000000000000001000000000000\\
00000000000000000000100000000000\\
00000000000000000000010000000000\\
00000000000000000000001001000000\\
00000000000000000000000100000000\\
00000000000000000000000010000000\\
00000000000000000000000001000000\\
00000000000000000000000000100000\\
00000000000000000000000000010000\\
00000000000000000000000000001000\\
00000000000000000000000000000100\\
00000000000000000000000000000010\\
00000000000000000000000000000001
\end{bmatrix}.$$

Based on the first matrix, the PC bit position of the third sequence obtained according to Step 702 may be one or more of the following bits in the third sequence: 16, 18, 21, or 25.

When the PC bit position is the 16th bit in the third sequence, the bit checked by the PC bit position is a 13th bit in the third sequence; or when the PC bit position is the 18th bit in the third sequence, the bit checked by the PC bit position is one or more of the following bits in the third sequence: 11, 13, and 15; or when the PC bit position is the 21st bit in the third sequence, the bit checked by the PC bit position is a 14th bit in the third sequence; or when the PC bit position is the 25th bit in the third sequence, the bit checked by the PC bit position is a 22nd bit in the third sequence.

In a second possible example, the first matrix may alternatively be a 32×32 matrix below, and the first matrix may alternatively be represented as a matrix shown in FIG. 9:

$$\begin{bmatrix} 10000000000000000000000000000000 \\ 01000000000000000000000000000000 \\ 00100000000000000000000000000000 \\ 00010000000000000000000000000000 \\ 00001000000000000000000000000000 \\ 00000100000000000000000000000000 \\ 00000010000000000000000000000000 \\ 00000001000000000000000000000000 \\ 00000000100000000000000000000000 \\ 00000000010000000000000000000000 \\ 00000000001000000000000000000000 \\ 00000000000100000000100000000000 \\ 00000000000010000000000000000000 \\ 00000000000001000000000000100000 \\ 00000000000000100001010001000000 \\ 00000000000000010000000000000000 \\ 00000000000000001000000000000000 \\ 00000000000000000100000000000000 \\ 00000000000000000010000000000000 \\ 00000000000000000001000000000000 \\ 00000000000000000000100000000000 \\ 00000000000000000000010000000000 \\ 00000000000000000000001001000000 \\ 00000000000000000000000100000000 \\ 00000000000000000000000010000000 \\ 00000000000000000000000001000000 \\ 00000000000000000000000000100000 \\ 00000000000000000000000000010000 \\ 00000000000000000000000000001000 \\ 00000000000000000000000000000100 \\ 00000000000000000000000000000010 \\ 00000000000000000000000000000001 \end{bmatrix}.$$

Based on the first matrix, the PC bit position of the third sequence obtained according to Step 702 may be one or more of the following bits in the first sequence: 19, 21, 25, or 26.

When the PC bit position is the 19th bit in the third sequence, the bit checked by the PC bit position is a 14th bit in the third sequence; or when the PC bit position is the 21st bit in the third sequence, the bit checked by the PC bit position is one or more of the following bits in the third sequence: 11 and 14; or when the PC bit position is the 25th bit in the third sequence, the bit checked by the PC bit position is one or more of the following bits in the third sequence: 14 and 22; or when the PC bit position is the 26th bit in the third sequence, the bit checked by the PC bit position is a 13th bit in the third sequence.

In a first possible design, different from representing, by using the first matrix, the PC bit position and the bit checked by the PC bit position described above, the PC bit position and the bit checked by the PC bit position may alternatively be represented by using a PC equation set, or it is described as that the first matrix is represented by using a PC equation set.

The PC equation set may include one or more PC equations, and a quantity of PC equations included in the PC equation set is equal to a quantity of PC bit positions (or it may be described as a quantity of columns whose column weights are greater than 1 in the first matrix). Each PC equation includes at least two elements, a maximum value of an element in each PC equation represents a PC bit position (or it may be described as that the maximum value represents a column number whose column weight is greater than 1 in the first matrix), and an element other than the PC bit position in each PC equation represents a bit checked by the PC bit position.

In a first possible example, if the PC equation set is {[13 16]}, it may be determined that the quantity of PC bit positions is 1, the PC bit position is 16, and the bit checked by the PC bit position is 13. If the PC equation set is {[11 13 15 18]}, it may be determined that the quantity of PC bit positions is 1, the PC bit position is 18, and bits checked by the PC bit position are 11, 13, and 15. If the PC equation set is {[14 21]}, it may be determined that the quantity of PC bit positions is 1, the PC bit position is 21, and the bit checked by the PC bit position is 14. If the PC equation set is {[22 25]}, it may be determined that the quantity of PC bit positions is 1, the PC bit position is 25, and the bit checked by the PC bit position is 21. If the PC equation set is {[13 16], [11 13 15 18], [14 21], [22 25]}, it may be determined that the quantity of PC bit positions is 4, PC bit positions are 16, 18, 21, and 25, the bit checked by the PC bit position 16 is 13, bits checked by the PC bit position 18 are 11, 13, and 15, the bit checked by the PC bit position 21 is 14, and the bit checked by the PC bit position 25 is 22.

In a second possible example, if the PC equation set is {[14 19]}, it may be determined that the quantity of PC bit positions is 1, the PC bit position is 19, and the bit checked by the PC bit position is 14. If the PC equation set is {[11 14 21]}, it may be determined that the quantity of PC bit positions is 1, the PC bit position is 21, and bits checked by the PC bit position are 11 and 14. If the PC equation set is {[14 22 25]}, it may be determined that the quantity of PC bit positions is 1, the PC bit position is 25, and bits checked by the PC bit position are 14 and 22. If the PC equation set is {[13 26]}, it may be determined that the quantity of PC bit positions is 1, the PC bit position is 26, and the bit checked by the PC bit position is 13. If the PC equation set is {[14 19], [11 14 21], [14 22 25], [13 26]}, it may be determined that the quantity of PC bit positions is 4, PC bit positions are 19, 21, 25, and 26, the bit checked by the PC bit position 19 is 14, bits checked by the PC bit position 21 are 11 and 14, bits checked by the PC bit position 25 are 14 and 22, and the bit checked by the PC bit position 26 is 13.

Based on the first possible design, when the first matrix is represented by using the PC equation set, multiplying the second sequence $a_0^{N-1}$ by the first matrix $T_{pre}$ to obtain the third sequence $v_0^{N-1} = a_0^{N-1}T_{pre}$ may be represented as:

$$\text{for n=0 to N}-1;$$

$$\text{if n} \in \text{F}$$

$$\text{for p=0: to }|\text{PF}|$$

$$\text{pcIdx= max( PF(p) );}$$

$$\text{chkIdx=the other indexes in PF(p);}$$

$$\text{if n == pcIdx}$$

$$v_n=\text{mod}(\textstyle\sum_{i\in\text{chkIdx}} a_i , 2)$$

$$\text{else}$$

$$v_n=0$$

$$\text{end}$$

$$\text{end}$$

$$\text{else}$$

$$v_n=a_n;$$

$$\text{end}$$

N represents a sequence length (for example, 32, and N-1 may be 31), F represents a frozen bit position set, PF represents a PC equation set, pcIdx represents a PC bit position, PF(p) represents a $p^{th}$ PC equation in the PC equation set, chkIdx represents a bit checked by the PC bit position, $v_n$ represents an $n^{th}$ value in the third sequence, $a_i$ represents an $i^{th}$ value in the second sequence, and $a_n$ represents an $n^{th}$ value in the second sequence.

In a second possible design, different from representing, by using the first matrix or the PC equation set, the PC bit position and the bit checked by the PC bit position described above, the PC bit position and the bit checked by the PC bit position may alternatively be represented by using a PC bit position set and a bit set corresponding to the PC bit position, or it is described as that the first matrix or the PC equation set is represented by using a PC bit position set and a bit set corresponding to the PC bit position.

The PC bit position set includes one or more PC bit positions (or it is described as that an element in the PC bit position set represents a column number whose column weight is greater than 1 in the first matrix, and a quantity of elements included in the PC bit position set is a quantity of columns whose column weights are greater than 1 in the first matrix), and the bit set corresponding to the PC bit position includes one or more bits checked by the PC bit position.

In a first possible example, if the PC bit position set is {16}, and the bit set corresponding to the PC bit position is {13}, it may be determined that the quantity of PC bit positions is 1, the PC bit position is 16, and the bit checked by the PC bit position is 13. If the PC bit position set is {18}, and the bit set corresponding to the PC bit position is {11 13 15}, it may be determined that the quantity of PC bit positions is 1, the PC bit position is 18, and bits checked by the PC bit position are 11, 13, and 15. If the PC bit position set is {21}, and the bit set corresponding to the PC bit position is {14}, it may be determined that the quantity of PC bit positions is 1, the PC bit position is 21, and the bit checked by the PC bit position is 14. If the PC bit position set is {25}, and the bit set corresponding to the PC bit position is {22}, it may be determined that the quantity of PC bit positions is 1, the PC bit position is 25, and the bit checked by the PC bit position is 21. If the PC bit position set is {16 18 21 25}, and the bit set corresponding to the PC bit position is {[13], [11 13 15], [14], [22]}, it may be determined that the quantity of PC bit positions is 4, PC bit positions are 16, 18, 21, and 25, the bit checked by the PC bit position 16 is 13, bits checked by the PC bit position 18 are 11, 13, and 15, the bit checked by the PC bit position 21 is 14, and the bit checked by the PC bit position 25 is 22.

In a second possible example, if the PC bit position set is {19}, and the bit set corresponding to the PC bit position is {14}, it may be determined that the quantity of PC bit positions is 1, the PC bit position is 19, and the bit checked by the PC bit position is 14. If the PC bit position set is {21}, and the bit set corresponding to the PC bit position is {11 14}, it may be determined that the quantity of PC bit positions is 1, the PC bit position is 21, and bits checked by the PC bit position are 11 and 14. If the PC bit position set is {25}, and the bit set corresponding to the PC bit position is {14 22}, it may be determined that the quantity of PC bit positions is 1, the PC bit position is 25, and bits checked by the PC bit position are 14 and 22. If the PC bit position set is {26}, and the bit set corresponding to the PC bit position is {13}, it may be determined that the quantity of PC bit positions is 1, the PC bit position is 26, and the bit checked by the PC bit position is 13. If the PC bit position set is {19 21 25 26}, and the bit set corresponding to the PC bit position is {[14], [11 14], [14 22], [13]}, it may be determined that the quantity of PC bit positions is 4, PC bit positions are 19, 21, 25, and 26, the bit checked by the PC bit position 19 is 14, bits checked by the PC bit position 21 are 11 and 14, bits checked by the PC bit position 25 are 14 and 22, and the bit checked by the PC bit position 26 is 13.

Based on the second possible design, when the first matrix is represented by using the PC bit position set and the bit set corresponding to the PC bit position, multiplying the second sequence $a_0^{N-1}$ by the first matrix $T_{pre}$ to obtain the third sequence $v_0^{N-1} = a_0^{N-1}T_{pre}$ may be represented as:

$$v_i = \begin{cases} a_i, & i \notin \mathbf{PBS} \\ a_i = \sum_{j,j\in\mathbf{CBS}} a_j & a_{j,j\in\mathbf{PBS}}, & i \in \mathbf{PBS} \end{cases}, i = \{0,1,2,\dots,N-1\}.$$

N represents a sequence length (for example, 32, and N-1 may be 31), $v_i$ represents an $i^{th}$ value in the third sequence, $a_i$ represents an $i^{th}$ value in the second sequence, $a_j$ represents a $j^{th}$ value in the second sequence, PBS represents a PC bit position set, and CBS represents a bit set corresponding to the PC bit position.

Based on the foregoing description of the PC bit position and the bit checked by the PC bit position, in the foregoing examples, the PC bit position and the bit checked by the PC bit position are defined starting from 0 bits. It may be understood that the PC bit position and the bit checked by the PC bit position may alternatively be defined starting from 1 bit, that is, 0, 1, ..., and 31 described above may be respectively replaced with 1, 2, ..., and 32. This is not limited.

Step 703: The transmit end device performs polar encoding on the third sequence to obtain a fourth sequence.

The transmit end device may multiply the third sequence by a polar encoding matrix, to obtain the fourth sequence.

For example, the polar encoding matrix may be $G_N$, $G_N$ is a $\log_2 N$ Kronecker product of $G_2$, $G_2 = \begin{bmatrix} 1 & 0 \\ 1 & 1 \end{bmatrix}$, and $G_N = G_2^{\otimes \log_2 N}$.

Optionally, an example in which the definition starts from 0 bits is used, and the fourth sequence may be denoted as $c_0^{N-1}$, and $c_0^{N-1} = v_0^{N-1}G_N$. It may be understood that the definition may alternatively start from 1 bit, that is, the third sequence may be denoted as $c_1^N$, and $c_1^N = v_1^N G_N$. This is not limited.

Based on the method shown in FIG. 7, an embodiment of this application provides a coding scheme based on a nested PC polar code, to separately construct, for an information bit sequence, a reliability sequence whose length is N and that has a nesting characteristic. In this way, when puncturing is performed in a back-to-front order, a quantity of performance bad points is reduced, code spectrum characteristics are improved, and decoding performance is improved. In addition, in this embodiment of this application, polar codes can be constructed based on a same first matrix for sequences of different quantities of information bits, that is, the first matrix has a nesting characteristic for the sequences of different quantities of information bits, and the first matrix does not change with a change of a quantity of information bits of the sequences; or it may be described that PC bit positions and PC equations corresponding to the sequences of different quantities of information bits are nested, and there is no need to separately store corresponding PC bit positions and PC equations for the information bit sequences of different lengths, thereby reducing hardware complexity, reducing hardware overheads, improving code spectrum characteristics, reducing decoding complexity, and improving decoding performance (for example, a successive cancellation list (successive cancellation list, SCL) decoding module is multiplexed, and decoding performance of the SCL decoding module (such as SCL8) is improved).

Based on the method shown in FIG. 7, after determining the fourth sequence based on polar encoding, the transmit end device may further perform interleaving processing on the fourth sequence based on an interleaving pattern, to obtain an interleaved sequence.

In a first possible design, interleaving processing may be performed on the fourth sequence based on a first interleaving pattern, to obtain a fifth sequence.

The first interleaving pattern may be determined based on sequence performance and a nesting characteristic by designing a search algorithm, that is, the first interleaving pattern has a nesting characteristic for sequences of different quantities of information bits, and does not change with a change of a length of the information bit sequence. Compared with designing the first interleaving pattern in an enumeration manner in which N! cases need to be enumerated (for example, when N is equal to 32, $32!=2.6313 \times 1035$ cases need to be enumerated), in this embodiment of this application, the first interleaving pattern is designed by designing a search algorithm. This can greatly reduce complexity while ensuring optimal sequence performance and nesting characteristic.

For example, puncturing position search may be performed on a plurality of fourth sequence samples (the plurality of fourth sequence samples may correspond to information bit sequences of different lengths, and a length of each information bit sequence is less than or equal to K) by using a list search algorithm. Each time a quantity of punctures increases by 1, average sequence performance of all sequences is calculated, the average sequence performance is used as a metric (Metric), and a position corresponding to optimal average sequence performance is determined as the puncturing position, to generate the first interleaving pattern. The average performance is an average value of SNR@BLER=1E-2 of the sequences.

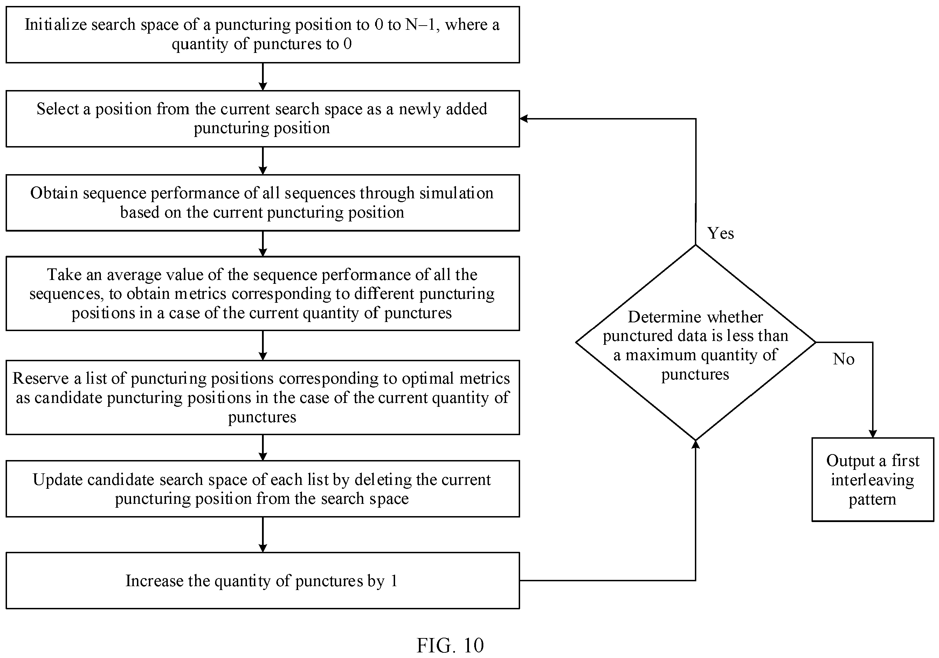

Specifically, as shown in FIG. 10, the search process may include:

Step 1: Initialize search space of the puncturing position to 0 to N-1, and the quantity of punctures to 0.

Step 2: Select a position from the current search space as a newly added puncturing position.

Step 3: Obtain sequence performance of all sequences through simulation based on the current puncturing position.

Step 4: Take an average value of the sequence performance of all the sequences, to obtain metrics corresponding to different puncturing positions in a case of the current quantity of punctures.

Step 5: Reserve a list of puncturing positions corresponding to optimal metrics as candidate puncturing positions in the case of the current quantity of punctures.

Step 6: Update candidate search space of each list by deleting the current puncturing position from the search space.

Step 7: Increase the quantity of punctures by 1.

Step 8: Determine whether punctured data is less than a maximum quantity of punctures; and if the punctured data is less than the maximum quantity of punctures, continue performing from Step 2 until the quantity of punctures is equal to a maximum of punctured data; or if the punctured data is not less than the maximum quantity of punctures, output the first interleaving pattern (or may be referred to as an optimal puncturing pattern).

The first interleaving pattern determined based on the foregoing search process may also be described as follows: The first interleaving pattern may indicate to place a value of a $y^{th}$ bit of the fourth sequence in an $(N-y-1)^{th}$ bit of the fifth sequence through swapping, where $0 \leq y \leq N-k-2$, y is an integer, and $k+1 \leq N-y-1 \leq N-1$.

Values of k+1 bits other than the $y^{th}$ bit in the fourth sequence may be randomly placed in the $0^{th}$ bit to the $k^{th}$ bit in the fifth sequence. This is not limited.

The $y^{th}$ bit may be determined based on average sequence performance obtained by removing a same bit from N-y-1 bits of the plurality of fourth sequence samples. Lengths of a plurality of information bit sequence samples corresponding to the plurality of fourth sequence samples are less than or equal to K, the lengths of the plurality of information bit sequence samples include k, and the N-y-1 bits do not include first y-1 bits of the $y^{th}$ bit.

Optionally, after a same bit is removed from the N-y-1 bits of the plurality of fourth sequence samples, when average sequence performance is optimal, the removed bit is the $y^{th}$ bit.

For example, the following uses an example in which the fourth sequence samples include a fourth sequence corresponding to an information bit sequence whose length is k=k1 and a fourth sequence corresponding to an information bit sequence whose length is k=k2 to describe in detail a manner of generating the first interleaving pattern having a nesting characteristic.

Step 1: Randomly generate a first random sequence (namely, an information bit sequence) whose length is k1 and a second random sequence (namely, an information bit sequence) whose length is k2, where k1 and k2 are lengths of to-be-encoded information bit sequences, and k1 and k2 are not equal.

Step 2: Perform polar encoding on the first random sequence and the second random sequence separately according to the method shown in FIG. 7, to obtain a first random codeword sequence (namely, a fourth sequence) and a second random codeword sequence (namely, a fourth sequence) whose lengths are N.

Step 3: Determine a value of first performance of a sequence obtained by puncturing a $g^{th}$ position of the first random codeword sequence and a value of first performance of a sequence obtained by puncturing a $g^{th}$ position of the second random codeword sequence, where $0 \leq g \leq N-1$.

Step 4: Determine an average value $A_g$ of a first value and a second value, where the first value is the value of the first performance of the sequence obtained by puncturing the $g^{th}$ position of the first random codeword sequence, and the second value is the value of the first performance of the sequence obtained by puncturing the $g^{th}$ position of the second random codeword sequence.

Step 5: Determine a $y^{th}$ bit (y=0), where the $y^{th}$ bit (y=0) is a position corresponding to a minimum value in $A_0$ to $A_{N-1}$, and the $y^{th}$ bit (y=0) is a $1^{st}$ puncturing position.

Step 6: Determine that a quantity 1 of puncturing positions is equal to (N-E), and generate a first interleaving pattern, where the first interleaving pattern indicates that after the fourth sequence is interleaved based on the first interleaving pattern, a value of the $y^{th}$ bit (y=0) of the fourth sequence is placed in the last bit of the fifth sequence through swapping. E represents a length of a rate matching sequence.

Alternatively,

Step 7: Determine that a quantity 1 of puncturing positions is less than (N-E), and randomly generate a third random sequence (namely, an information bit sequence) whose length is k1 and a fourth random sequence (namely, an information bit sequence) whose length is k2.

Step 8: Perform polar encoding on the third random sequence and the fourth random sequence separately according to the method shown in FIG. 7, to obtain a third random codeword sequence (namely, a fourth sequence) and a fourth random codeword sequence (namely, a fourth sequence) whose lengths are N.

Step 9: Determine a fifth random codeword sequence and a sixth random codeword sequence, where the fifth random codeword sequence is a sequence obtained by puncturing a bit in the $y^{th}$ bit (y=0) of the third random codeword sequence, and the sixth random codeword sequence is a sequence obtained by puncturing a bit in the $y^{th}$ bit (y=0) of the fourth random codeword sequence.

Step 10: Determine a value of first performance of a sequence obtained by puncturing an $h^{th}$ position of the fifth random codeword sequence and a value of first performance of a sequence obtained by puncturing an $h^{th}$ position of the sixth random codeword sequence, where $0 \leq h \leq N-2$.

Step 11: Determine an average value $A_h$ of a third value and a fourth value, where the third value is the value of the first performance of the sequence obtained by puncturing the $h^{th}$ position of the fifth random codeword sequence, and the fourth value is the value of the first performance of the sequence obtained by puncturing the $h^{th}$ position of the sixth random codeword sequence.

Step 12: Determine a $y^{th}$ bit (y=1), where the $y^{th}$ bit (y=1) is a position corresponding to a minimum value in $A_1$ to $A_{N-2}$, and the $y^{th}$ bit (y=1) is a $2^{nd}$ puncturing position.

Step 13: Determine that a quantity 2 of puncturing positions is equal to (N-E), and generate a first interleaving pattern, where the first interleaving pattern indicates that after the fourth sequence is interleaved based on the first interleaving pattern, a value of the $y^{th}$ bit (y=0) of the fourth sequence is placed in the last bit of the fifth sequence through swapping, and a value of the $y^{th}$ bit (y=1) of the fourth sequence is placed in the penultimate bit of the fifth sequence through swapping.

Alternatively,

Step 14: Determine that a quantity 2 of puncturing positions is less than (N-E), and repeatedly perform the foregoing operations until the quantity of puncturing positions is equal to E, to generate a corresponding first interleaving pattern.

The foregoing is described by using only an example in which the first interleaving pattern having the nesting characteristic is generated based on the fourth sequence corresponding to k1 and the fourth sequence corresponding to k2 (that is, interleaving processing may be performed on both the fourth sequence corresponding to k1 and the fourth sequence corresponding to k2 based on the foregoing first interleaving pattern). It may be understood that for a plurality of fourth sequences corresponding to different ks, the first interleaving pattern having the nesting characteristic may be generated in the foregoing manner.

For example, an example in which k is equal to 3, 4, ..., or 11 is used. The first interleaving pattern having the nesting characteristic may be generated in the foregoing manner based on a fourth sequence corresponding to k being 3, 4, ..., or 11. To be specific, interleaving processing may be performed on the fourth sequence corresponding to k being equal to 3, the fourth sequence corresponding to k being equal to 4, ..., and the fourth sequence corresponding to k being equal to 11 based on the first interleaving pattern.

In an example, the maximum value of the length k of the information bit sequence is 11, the minimum value is 3, and N is 32. The first interleaving pattern may indicate to place a value of an $A^{th}$ bit of the fourth sequence in a $B^{th}$ bit of the fifth sequence through swapping; and a mapping relationship between A and B is: (5, 31), (26, 30), (11, 29), (9, 28), (28, 27), (7, 26), (30, 25), (16, 24), (31, 23), (21, 22), (10, 21), (24, 20), (27, 19), (6, 18), (3, 17), (12, 16), (17, 15), (8, 14), (13, 13), (0, 12), (2, 11), (1, 10), (4, 9), (14, 8), (25, 7), (23, 6), (22, 5), and (19, 4).

The first A (namely, 5) is the $y^{th}$ bit in a case of y=0, the second A (namely, 26) is the $y^{th}$ bit in a case of y=1, ..., the (N-K-1=32-11-1=20)$^{th}$ A (namely, 0) is the $y^{th}$ bit in a case of y=N-K-2=32-11-2=19, ..., and the (N-k-1=32-3-1=28)$^{th}$ A (namely, 19) is the $y^{th}$ bit in a case of y=N-k-2=32-11-2=27.

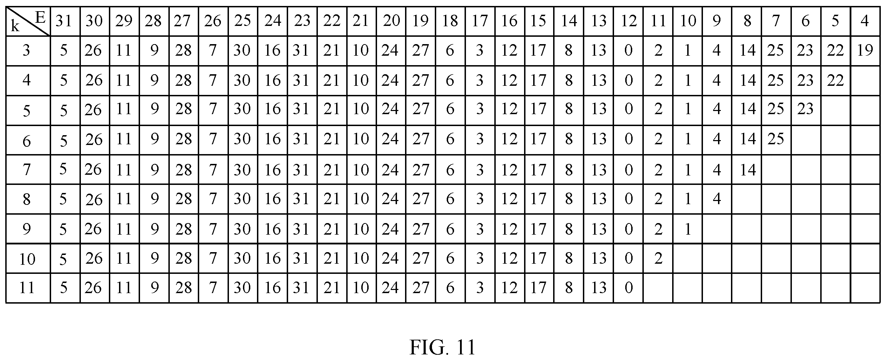

The first interleaving pattern may be represented as an interleaving pattern shown in Table 6, or may be represented as an interleaving pattern shown in FIG. 11.

Table 6

| B | A | B | A | B | A | B | A | B | A | B | A | B | A | B | A |
|---|---|---|---|---|---|---|---|---|---|---|---|---|---|---|---|
| 0 | 29 | 4 | 19 | 8 | 14 | 12 | 0 | 16 | 12 | 20 | 24 | 24 | 16 | 28 | 9 |
| 1 | 20 | 5 | 22 | 9 | 4 | 13 | 13 | 17 | 3 | 21 | 10 | 25 | 30 | 29 | 11 |
| 2 | 18 | 6 | 23 | 10 | 1 | 14 | 8 | 18 | 6 | 22 | 21 | 26 | 7 | 30 | 26 |
| 3 | 15 | 7 | 25 | 11 | 2 | 15 | 17 | 19 | 27 | 23 | 31 | 27 | 28 | 31 | 5 |

It may be understood that the first four groups of mapping relationships between A and B in Table 6 may be determined randomly, that is, 29, 20, 18, and 15 in A may randomly correspond to 0, 1, 2, and 3 in B. This is not limited.

In another example, the maximum value of the length k of the information bit sequence is 11, the minimum value is 3, and N is 32. The first interleaving pattern may indicate to place a value of an $A^{th}$ bit of the fourth sequence in a $B^{th}$ bit of the fifth sequence through swapping; and a mapping relationship between A and B is: (4, 31), (22, 30), (27, 29), (17, 28), (8, 27), (2, 26), (15, 25), (21, 24), (29, 23), (23, 22), (6, 21), (26, 20), (20, 19), (7, 18), (0, 17), (13, 16), (19, 15), (11, 14), (14, 13), (16, 12), (25, 11), (3, 10), (10, 9), (5, 8), (12, 7), (1, 6), (18, 5), and (24, 4).

The first A (namely, 4) is the $y^{th}$ bit in a case of y=0, the second A (namely, 22) is the $y^{th}$ bit in a case of y=1, ..., the (N-K-1=32-11-1=20)$^{th}$ A (namely, 16) is the $y^{th}$ bit in a case of y=N-K-2=32-11-2=19, ..., and the (N-k-1=32-3-1=28)$^{th}$ A (namely, 24) is the $y^{th}$ bit in a case of y=N-k-2=32-11-2=27.

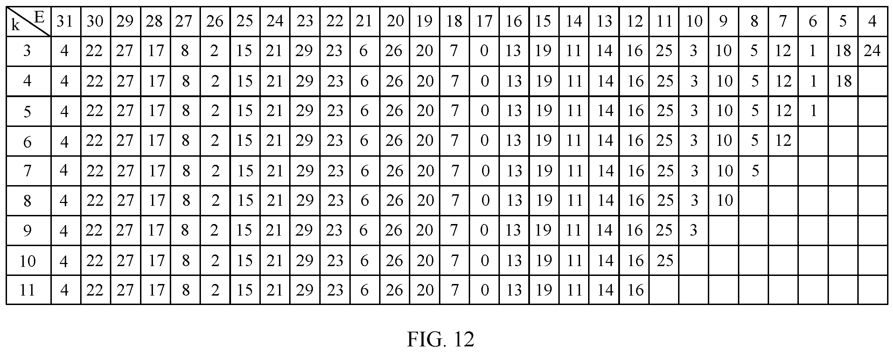

The first interleaving pattern may be an interleaving pattern shown in Table 7, or may be represented as an interleaving pattern shown in FIG. 12.

Table 7

| B | A | B | A | B | A | B | A | B | A | B | A | B | A | B | A |
|---|---|---|---|---|---|---|---|---|---|---|---|---|---|---|---|
| 0 | 9 | 4 | 24 | 8 | 5 | 12 | 16 | 16 | 13 | 20 | 26 | 24 | 21 | 28 | 17 |
| 1 | 28 | 5 | 18 | 9 | 10 | 13 | 14 | 17 | 0 | 21 | 6 | 25 | 15 | 29 | 27 |
| 2 | 30 | 6 | 1 | 10 | 3 | 14 | 11 | 18 | 7 | 22 | 23 | 26 | 2 | 30 | 22 |
| 3 | 31 | 7 | 12 | 11 | 25 | 15 | 19 | 19 | 20 | 23 | 29 | 27 | 8 | 31 | 4 |

It may be understood that the first four groups of mapping relationships between A and B in Table 7 may be determined randomly, that is, 9, 28, 30, and 31 in A may randomly correspond to 0, 1, 2, and 3 in B. This is not limited.

Based on the foregoing first interleaving pattern, because the first interleaving pattern has the nesting characteristic, there is no need to separately store an interleaving pattern for sequences of different quantities of information bits, thereby reducing hardware complexity and reducing hardware overheads. Because the first interleaving pattern is determined based on sequence performance, it can be ensured that there is no bad point in rate matching performance (for example, there is no bad point in 1-bit fine-grained rate matching performance), and decoding performance is improved.

It may be understood that interleaving patterns may alternatively be separately stored for the sequences of different quantities of information bits, that is, first interleaving patterns are separately stored for the sequences of different quantities of information bits. This is not limited.

In a second possible design, interleaving processing may alternatively be performed on the fourth sequence based on the second interleaving pattern, to obtain a sixth sequence.

Different from the first interleaving pattern that has the nesting characteristic in the first possible design, in the second possible design, sequences of different quantities of information bits may correspond to different second interleaving patterns, that is, the second interleaving patterns are separately designed for the sequences of different quantities of information bits.

In this embodiment of this application, the second interleaving pattern may be designed with reference to the search algorithm in the first possible design. This can greatly reduce complexity while ensuring optimal sequence performance.

For example, puncturing position search may be performed on a plurality of fourth sequence samples (the plurality of fourth sequence samples may correspond to information bit sequences of a same length, and a length of the information bit sequence is less than or equal to K) by referring to the list search algorithm. Each time a quantity of punctures increases by 1, average sequence performance of all sequences is calculated, the average sequence performance is used as a metric (Metric), and a position corresponding to optimal average sequence performance is determined as the puncturing position, to generate the second interleaving pattern. The average performance is an average value of SNR@BLER=1E-2 of the sequences.

The second interleaving pattern determined based on the foregoing search process may also be described as follows: The second interleaving pattern indicates to place a value of a $y^{th}$ bit of the fourth sequence in an $(N-y-1)^{th}$ bit of the sixth sequence through swapping, where $1 \le y \le N-k-2$, y is a positive integer, and $k+1 \le N-y-1 \le N-1$.

Values of k+1 bits other than the $y^{th}$ bit in the fourth sequence may be randomly placed in the $0^{th}$ bit to the $k^{th}$ bit in the sixth sequence. This is not limited.

The $y^{th}$ bit is determined based on average sequence performance obtained by removing 1 bit from N-y-1 bits of the plurality of fourth sequence samples. Lengths of a plurality of information bit sequence samples corresponding to the plurality of fourth sequence samples are all k, and the N-y-1 bits do not include first y-1 bits of the $y^{th}$ bit.

Optionally, after 1 bit is removed from the N-y-1 bits of the fourth sequence samples, when average sequence performance is optimal, the removed bit is the $y^{th}$ bit.

In an example, the maximum value of the length k of the information bit sequence is 11, the minimum value is 3, and N is 32. The second interleaving pattern may indicate to place a value of an $A^{th}$ bit of the fourth sequence in a $B^{th}$ bit of the sixth sequence through swapping.

When k is 3, a mapping relationship between A and B is: (12, 31), (9, 30), (19, 29), (18, 28), (1, 27), (15, 26), (14, 25), (29, 24), (16, 23), (10, 22), (28, 21), (23, 20), (20, 19), (6, 18), (21, 17), (7, 16), (2, 15), (25, 14), (0, 13), (3, 12), (5, 11), (31, 10), (30, 9), (4, 8), (22, 7), (13, 6), (27, 5), and (8, 4).

Alternatively, when k is 4, a mapping relationship between A and B is: (18, 31), (29, 30), (9, 29), (12, 28), (27, 27), (22, 26), (23, 25), (26, 24), (4, 23), (0, 22), (7, 21), (14, 20), (8, 19), (19, 18), (1, 17), (21, 16), (13, 15), (11, 14), (17, 13), (20, 12), (16, 11), (15, 10), (6, 9), (10, 8), (28, 7), (25, 6), and (24, 5).

Alternatively, when k is 5, a mapping relationship between A and B is: (2, 31), (20, 30), (12, 29), (25, 28), (8, 27), (22, 26), (16, 25), (5, 24), (29, 23), (14, 22), (23, 21), (15, 20), (3, 19), (11, 18), (10, 17), (17, 16), (0, 15), (30, 14), (18, 13), (27, 12), (4, 11), (19, 10), (21, 9), (6, 8), (26, 7), and (9, 6).

Alternatively, when k is 6, a mapping relationship between A and B is: (19, 31), (23, 30), (16, 29), (18, 28), (29, 27), (0, 26), (21, 25), (8, 24), (11, 23), (4, 22), (13, 21), (2, 20), (20, 19), (24, 18), (25, 17), (6, 16), (28, 15), (14, 14), (10, 13), (9, 12), (31, 11), (26, 10), (7, 9), (17, 8), and (1, 7).

Alternatively, when k is 7, a mapping relationship between A and B is: (7, 31), (9, 30), (19, 29), (26, 28), (31, 27), (21, 26), (27, 25), (2, 24), (23, 23), (17, 22), (10, 21), (30, 20), (25, 19), (24, 18), (0, 17), (16, 16), (4, 15), (11, 14), (20, 13), (12, 12), (29, 11), (18, 10), (13, 9), and (3, 8).

Alternatively, when k is 8, a mapping relationship between A and B is: (15, 31), (16, 30), (9, 29), (14, 28), (17, 27), (24, 26), (21, 25), (20, 24), (5, 23), (1, 22), (7, 21), (30, 20), (11, 19), (6, 18), (2, 17), (3, 16), (8, 15), (22, 14), (12, 13), (23, 12), (19, 11), (10, 10), and (29, 9).

Alternatively, when k is 9, a mapping relationship between A and B is: (17, 31), (21, 30), (15, 29), (14, 28), (4, 27), (24, 26), (8, 25), (29, 24), (19, 23), (16, 22), (7, 21), (2, 20), (9, 19), (25, 18), (26, 17), (23, 16), (28, 15), (30, 14), (13, 13), (6, 12), (22, 11), and (0, 10).

Alternatively, when k is 10, a mapping relationship between A and B is: (28, 31), (29, 30), (14, 29), (26, 28), (8, 27), (23, 26), (24, 25), (30, 24), (0, 23), (31, 22), (10, 21), (5, 20), (20, 19), (4, 18), (16, 17), (12, 16), (9, 15), (21, 14), (1, 13), (11, 12), and (22, 11).

Alternatively, when k is 11, a mapping relationship between A and B is: (22, 31), (19, 30), (28, 29), (9, 28), (4, 27), (6, 26), (14, 25), (11, 24), (3, 23), (13, 22), (0, 21), (15, 20), (26, 19), (24, 18), (27, 17), (18, 16), (21, 15), (17, 14), (20, 13), and (12, 12).

The first A is the $y^{th}$ bit in a case of y=0, the second A is the $y^{th}$ bit in a case of y=1, ..., the $(N-K-1=32-11-1=20)^{th}$ A (namely, 0) is the $y^{th}$ bit in a case of y=N-K-2=32-11-2=19, ..., and the $(N-k-1)^{th}$ A is the $y^{th}$ bit in a case of y=N-k-2.

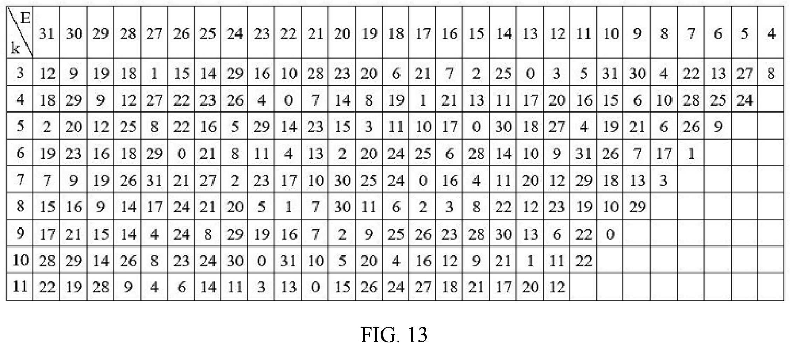

Optionally, the second interleaving pattern may alternatively be represented as an interleaving pattern shown in FIG. 13.

Optionally, the second interleaving pattern may alternatively be represented as an interleaving pattern similar to that shown in Table 6 or Table 7. For example, k is 3, and the second interleaving pattern may be an interleaving pattern shown in Table 8 below.

Table 8

| B | A | B | A | B | A | B | A | B | A | B | A | B | A | B | A |
|---|---|---|---|---|---|---|---|---|---|---|---|---|---|---|---|
| 0 | 25 | 4 | 8 | 8 | 4 | 12 | 3 | 16 | 7 | 20 | 23 | 24 | 29 | 28 | 18 |
| 1 | 16 | 5 | 27 | 9 | 30 | 13 | 0 | 17 | 21 | 21 | 28 | 25 | 14 | 29 | 19 |
| 2 | 23 | 6 | 13 | 10 | 31 | 14 | 25 | 18 | 6 | 22 | 10 | 26 | 15 | 30 | 9 |
| 3 | 10 | 7 | 22 | 11 | 5 | 15 | 2 | 19 | 20 | 23 | 16 | 27 | 1 | 31 | 12 |

It may be understood that the first four groups of mapping relationships between A and B in Table 8 may be determined randomly, that is, 25, 16, 23, and 10 in A may randomly correspond to 0, 1, 2, and 3 in B. This is not limited.

In another example, the maximum value of the length k of the information bit sequence is 11, the minimum value is 3, and N is 32. The second interleaving pattern may indicate to place a value of an $A^{th}$ bit of the fourth sequence in a $B^{th}$ bit of the sixth sequence through swapping.

When k is 3, a mapping relationship between A and B is: (5, 31), (11, 30), (24, 29), (30, 28), (13, 27), (20, 26), (22, 25), (3, 24), (4, 23), (25, 22), (31, 21), (6, 20), (10, 19), (8, 18), (21, 17), (15, 16), (9, 15), (2, 14), (0, 13), (27, 12), (14, 11), (16, 10), (17, 9), (23, 8), (28, 7), (26, 6), (1, 5), and (7, 4).

When k is 4, a mapping relationship between A and B is: (16, 31), (28, 30), (10, 29), (30, 28), (19, 27), (7, 26), (13, 25), (9, 24), (11, 23), (6, 22), (8, 21), (26, 20), (21, 19), (20, 18), (23, 17), (25, 16), (0, 15), (17, 14), (27, 13), (22, 12), (18, 11), (15, 10), (5, 9), (12, 8), (2, 7), (29, 6), and (24, 5).

When k is 5, a mapping relationship between A and B is: (9, 31), (19, 30), (11, 29), (12, 28), (21, 27), (0, 26), (29, 25), (2, 24), (4, 23), (31, 22), (10, 21), (1, 20), (22, 19), (7, 18), (24, 17), (30, 16), (20, 15), (3, 14), (28, 13), (13, 12), (14, 11), (8, 10), (6, 9), (5, 8), (17, 7), and (18, 6).

When k is 6, a mapping relationship between A and B is: (11, 31), (25, 30), (31, 29), (27, 28), (14, 27), (0, 26), (22, 25), (19, 24), (18, 23), (3, 22), (20, 21), (2, 20), (4, 19), (17, 18), (23, 17), (24, 16), (12, 15), (1, 14), (7, 13), (10, 12), (28, 11), (26, 10), (6, 9), (5, 8), and (8, 7).

When k is 7, a mapping relationship between A and B is: (7, 31), (12, 30), (2, 29), (5, 28), (26, 27), (6, 26), (27, 25), (24, 24), (4, 23), (19, 22), (1, 21), (29, 20), (9, 19), (8, 18), (13, 17), (11, 16), (28, 15), (10, 14), (25, 13), (16, 12), (30, 11), (0, 10), (21, 9), and (3, 8).

When k is 8, a mapping relationship between A and B is: (7, 31), (30, 30), (17, 29), (16, 28), (19, 27), (6, 26), (29, 25), (18, 24), (10, 23), (3, 22), (24, 21), (9, 20), (21, 19), (28, 18), (31, 17), (12, 16), (23, 15), (2, 14), (15, 13), (4, 12), (27, 11), (20, 10), and (25, 9).

When k is 9, a mapping relationship between A and B is: (28, 31), (25, 30), (17, 29), (6, 28), (11, 27), (21, 26), (27, 25), (30, 24), (3, 23), (1, 22), (4, 21), (8, 20), (15, 19), (26, 18), (29, 17), (18, 16), (9, 15), (19, 14), (2, 13), (20, 12), (23, 11), and (10, 10).

When k is 10, a mapping relationship between A and B is: (23, 31), (30, 30), (3, 29), (28, 28), (14, 27), (19, 26), (9, 25), (16, 24), (29, 23), (13, 22), (26, 21), (12, 20), (18, 19), (0, 18), (15, 17), (4, 16), (20, 15), (1, 14), (25, 13), (31, 12), and (21, 11).

When k is 11, a mapping relationship between A and B is: (1, 31), (24, 30), (14, 29), (15, 28), (25, 27), (12, 26), (26, 25), (13, 24), (27, 23), (31, 22), (8, 21), (5, 20), (20, 19), (21, 18), (3, 17), (28, 16), (17, 15), (6, 14), (19, 13), and (11, 12).

The first A is the $y^{th}$ bit in a case of y=0, the second A is the $y^{th}$ bit in a case of y=1, ..., the $(N-K-1=32-11-1=20)^{th}$ A (namely, 0) is the $y^{th}$ bit in a case of y=N-K-2=32-11-2=19, ..., and the $(N-k-1)^{th}$ A is the $y^{th}$ bit in a case of y=N-k-2.

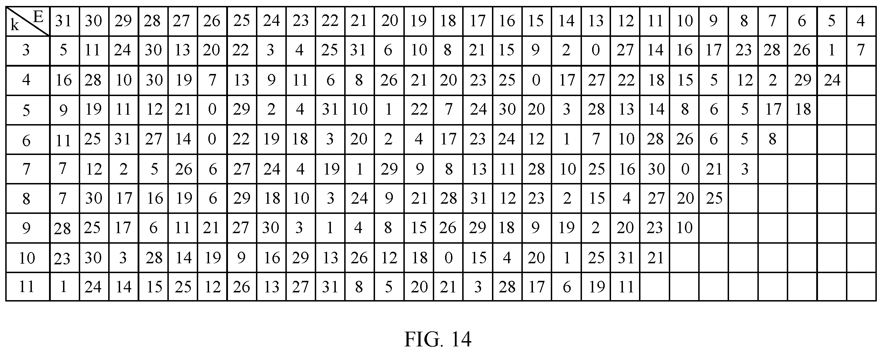

Optionally, the second interleaving pattern may alternatively be represented as an interleaving pattern shown in FIG. 14.

Optionally, the second interleaving pattern may alternatively be represented as an interleaving pattern similar to that shown in Table 6, Table 7, or Table 8. For example, k is 3, and the second interleaving pattern may be an interleaving pattern shown in Table 9 below.

Table 9

| B | A | B | A | B | A | B | A | B | A | B | A | B | A | B | A |
|---|---|---|---|---|---|---|---|---|---|---|---|---|---|---|---|
| 0 | 12 | 4 | 7 | 8 | 23 | 12 | 27 | 16 | 15 | 20 | 6 | 24 | 3 | 28 | 30 |
| 1 | 18 | 5 | 1 | 9 | 17 | 13 | 0 | 17 | 21 | 21 | 31 | 25 | 22 | 29 | 24 |
| 2 | 19 | 6 | 26 | 10 | 16 | 14 | 2 | 18 | 8 | 22 | 25 | 26 | 20 | 30 | 11 |
| 3 | 29 | 7 | 28 | 11 | 14 | 15 | 9 | 19 | 10 | 23 | 4 | 27 | 13 | 31 | 5 |

It may be understood that the first four groups of mapping relationships between A and B in Table 9 may be determined randomly, that is, 12, 18, 19, and 29 in A may randomly correspond to 0, 1, 2, and 3 in B. This is not limited.

In the foregoing two possible designs, various examples are defined starting from 0 bits. It may be understood that the definition may alternatively start from 1 bit, that is, 0, 1, ..., and 31 described above may be respectively replaced with 1, 2, ..., and 32. This is not limited.

Based on the foregoing description, after performing interleaving processing on the fourth sequence, the transmit end device may further perform rate matching on the fourth sequence (for example, the fifth sequence or the sixth sequence) obtained through interleaving processing.

A length of the fifth sequence and a length of the sixth sequence are both N.

A transmission code length E (that is, a length of the rate matching sequence) may be determined based on rate matching related information. When it is determined that the transmission code length E is not equal to N, the following rate matching manner may be used: When the transmission code length E is less than N, puncturing is performed from back to front; or when the transmission code length E is greater than N, repetition is performed from front to back.

That is, the transmit end device may perform rate matching on the fifth sequence whose length is N, to obtain a first rate matching sequence whose length is E. Alternatively, rate matching is performed on the sixth sequence whose length is N, to obtain a second rate matching sequence whose length is E.

For example, the fourth sequence is $c_0^{N-1}$. Interleaving processing may be performed on the fourth sequence based on an interleaving pattern (for example, the first interleaving pattern or the second interleaving pattern) with reference to the following description, to obtain a sequence $e_0^{N-1}$ obtained through interleaving processing:

$$\text{for } n=0 \text{ to } N-1$$
$$e_n = d_{P(n)}$$
$$\text{end for}$$

$e_n$ represents an $n^{th}$ value in a sequence obtained through interleaving processing, and $P(n)$ represents an interleaving pattern.

Rate matching is performed on the sequence $e_0^{N-1}$ obtained through interleaving processing, to obtain the rate matching sequence $f_0^{E-1}$ with reference to the following description:

$$\text{for } j=0 \text{ to } E-1$$
$$f_j = e_{j \bmod N}$$
$$\text{end for}$$

In an example, the length k of the information bit sequence corresponding to the fourth sequence whose length is 32 is 7, and the transmit end device performs interleaving processing based on the second interleaving pattern shown in FIG. 13. It is assumed that the length E of the rate matching sequence is 22, values of $7^{th}$ $9^{th}$, $19^{th}$, $26^{th}$, $31^{st}$, $21^{st}$, $27^{th}$, $2^{nd}$, $23^{rd}$, and $17^{th}$ bits of the fourth sequence need to be sequentially placed in the $31^{st}$ bit to the $22^{nd}$ bit of the sixth sequence, values of the remaining 22 bits of the fourth sequence are randomly placed in the $0^{th}$ bit to the $21^{st}$ bit of the sixth sequence, and values of the $22^{nd}$ bit to the $31^{st}$ bit of the sixth sequence are punctured, to obtain the second rate matching sequence. Alternatively, it may be described as follows: Values of $7^{th}$, $9^{th}$, $19^{th}$, $26^{th}$, $31^{st}$, $21^{st}$, $27^{th}$, $2^{nd}$, $23^{rd}$, and $17^{th}$ bits of the fourth sequence are punctured, and values of the remaining 22 bits are randomly arranged, to obtain the second rate matching sequence.

In another example, the length k of the information bit sequence corresponding to the fourth sequence whose length is 32 is 3, and the transmit end device performs interleaving processing based on the second interleaving pattern shown in FIG. 13. It is assumed that the length E of the rate matching sequence is 4, values of $12^{th}$ $9^{th}$, $19^{th}$, $18^{th}$, $1^{st}$, $15^{th}$, $14^{th}$, $29^{th}$, $16^{th}$, $10^{th}$, $28^{th}$, $23^{rd}$, $20^{th}$, $6^{th}$, $21^{st}$, $7^{th}$, $2^{nd}$, $25^{th}$, $0^{th}$, $3^{rd}$, $5^{th}$, $31^{st}$, $30^{th}$, $4^{th}$, $22^{nd}$, $13^{th}$, $27^{th}$, and $8^{th}$ bits of the fourth sequence need to be sequentially placed in the $31^{st}$ bit to the $4^{th}$ bit of the sixth sequence, values of the remaining 4 bits of the fourth sequence are randomly placed in the $0^{th}$ bit to the $3^{rd}$ bit of the sixth sequence, and values of the $4^{th}$ bit to the $31^{st}$ bit of the sixth sequence are punctured, to obtain the second rate matching sequence. Alternatively, it may be described as follows: Values of $12^{th}$ $9^{th}$, $19^{th}$, $18^{th}$, $1^{st}$, $15^{th}$ $14^{th}$, $29^{th}$, $16^{th}$, $10^{th}$, $28^{th}$, $23^{rd}$, $20^{th}$, $6^{th}$, $21^{st}$, $7^{th}$, $2^{nd}$, $25^{th}$, $0^{th}$, $3^{rd}$, $5^{th}$, $31^{st}$, $30^{th}$, $4^{th}$, $22^{nd}$, $13^{th}$, $27^{th}$, and $8^{th}$ bits of the fourth sequence are punctured, and values of the remaining 4 bits are randomly arranged, to obtain the second rate matching sequence.

Based on the foregoing description, it may be found that a larger value of k indicates a smaller quantity of supported punctures, and a maximum of N-1-k positions to be punctured can be supported.

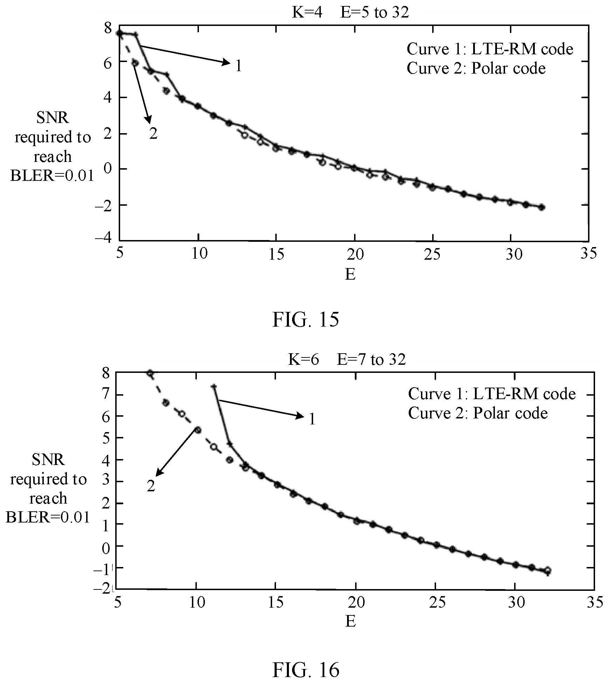

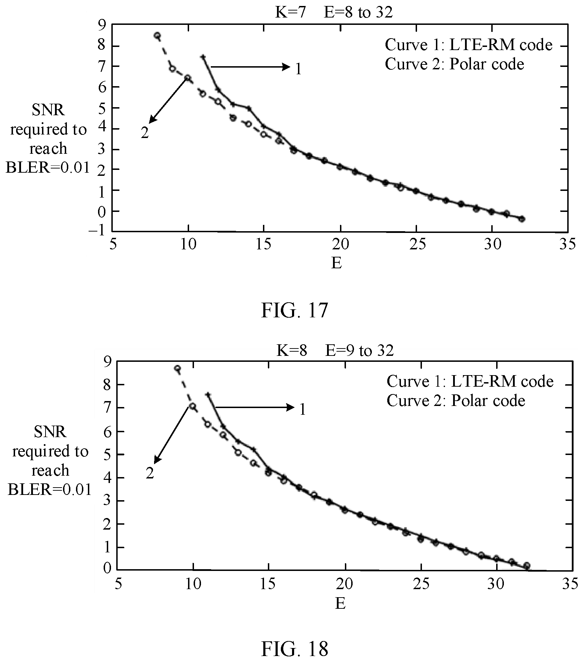

Based on the foregoing descriptions of polar encoding, interleaving, and rate matching, FIG. 15 to FIG. 19 are respectively diagrams of performance comparison between simulation effects of an LTE-RM code and a polar code provided in embodiments of this application in different code lengths and code rates.

A simulation channel is an AWGN channel, a modulation scheme is QPSK modulation, a coding scheme is the LTE-RM code, and a decoding scheme is FHT decoding; or a coding scheme is the polar code, and a decoding scheme is SCL8 decoding.

Each diagram of performance comparison has two curves in total. Curve 1 is performance obtained through rate matching performed in an LTE-RM code manner, and Curve 2 is performance obtained through rate matching performed in a polar code manner (that is, according to the method shown in FIG. 7 and based on the first interleaving pattern) provided in this embodiment of this application.

A horizontal axis in the diagram of performance comparison is a code length E after puncturing, and a value of the horizontal axis ranges from k+1 to N (for example, 32), and a vertical axis is an SNR required to reach BLER=0.01. A lower curve indicates better performance.

It can be learned from FIG. 15 to FIG. 17 that the polar code encoding method provided in embodiments of this application can greatly improve encoding and decoding performance.

It should be noted that, in the foregoing method, a very short code (very short codes) whose length of an information bit sequence is 3 to 11 is used as an example for description. It may be understood that the length of the very short code is not limited to 3 to 11, or may be another length. The information bit sequence may alternatively be a pre-transform polar (pre-transform polar) code, a polarization adjusted convolutional (polarization adjusted convolutional, PAC) code, or the like. This is not limited.

It should be noted that embodiments of this application may be implemented separately, or may be implemented in combination. This is not limited. Unless otherwise stated or there is a logic conflict, terms and/or descriptions in different embodiments provided by this application are consistent and may be mutually referenced, and technical features in different embodiments may be combined into a new embodiment based on an internal logical relationship thereof.

It may be understood that, in embodiments in this application, an execution body may perform a part or all of the steps in embodiments of this application. The steps or operations are merely examples. In embodiments of this application, other operations or variations of various operations may be further performed. In addition, the steps may be performed in a sequence different from a sequence presented in embodiments of this application, and not all the operations in embodiments of this application may be necessarily performed.

The solutions provided in embodiments of this application are mainly described above from a perspective of interaction between the devices. It may be understood that, to implement the foregoing functions, each device includes a corresponding hardware structure and/or a corresponding software module for performing each function. A person of ordinary skill in the art should easily be aware that, in combination with algorithms and steps in the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the devices may be divided into functional modules based on the foregoing method examples. For example, each functional module may be obtained through division based on each corresponding function, or two or more functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used.

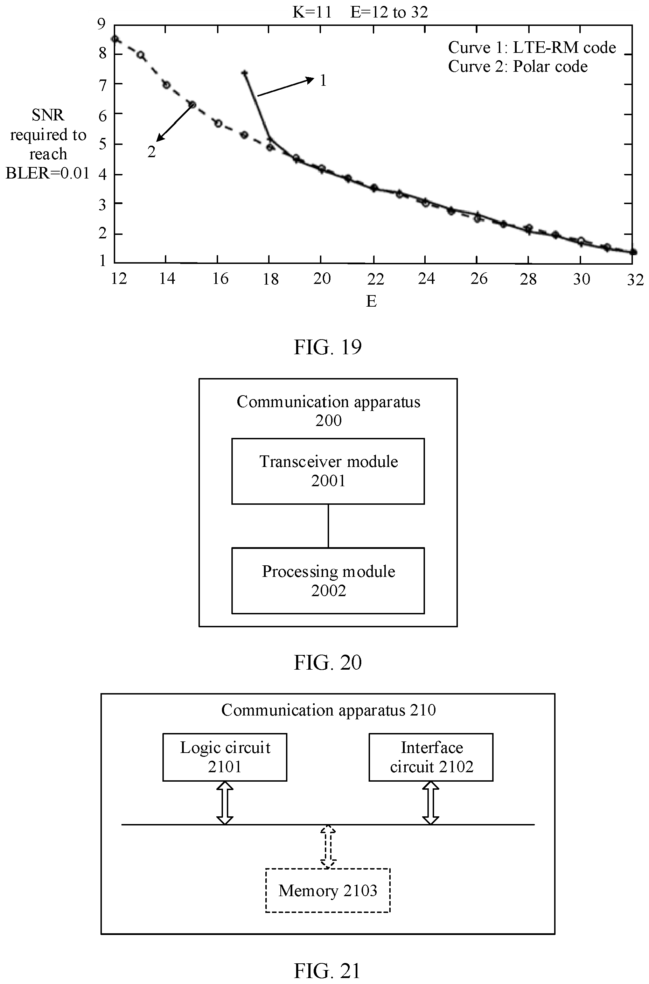

When each functional module is obtained through division based on each corresponding function, FIG. 20 shows a communication apparatus 200. The communication apparatus 200 may perform actions performed by the transmit end device in the methods shown in FIG. 7 to FIG. 19. All related content of steps in the foregoing method embodiments may be referenced in functional descriptions of corresponding functional modules. For technical effect that can be achieved by the communication apparatus 200, refer to the foregoing method embodiments. Details are not described herein again.

The communication apparatus 200 may include a transceiver module 2001 and a processing module 2002. For example, the communication apparatus 200 may be a communication device, or may be a chip used in the communication device, or another combined device or component that has a function of the communication apparatus. When the communication apparatus 200 is a communication device, the transceiver module 2001 may be a transceiver, where the transceiver may include an antenna, a radio frequency circuit, and the like; and the processing module 2002 may be a processor (or a processing circuit), for example, a baseband processor, where the baseband processor may include one or more CPUs. When the communication apparatus 200 is a component that has a function of the communication apparatus, the transceiver module 2001 may be a radio frequency unit, and the processing module 2002 may be a processor (or a processing circuit), for example, a baseband processor. When the communication apparatus 200 is a chip system, the transceiver module 2001 may be an input/output interface of a chip (for example, a baseband chip); and the processing module 2002 may be a processor (or a processing circuit) of the chip system, and may include one or more central processing units. It should be understood that the transceiver module 2001 in embodiments of this application may be implemented by a transceiver or a transceiver-related circuit component, and the processing module 2002 may be implemented by a processor or a processor-related circuit component (or referred to as a processing circuit).

For example, the transceiver module 2001 may be configured to perform all receiving and sending operations performed by the communication apparatus in embodiments shown in FIG. 7 to FIG. 19, and/or configured to support another process of the technology described in this specification. The processing module 2002 may be configured to perform all operations, other than the receiving and sending operations, performed by the communication apparatus in embodiments shown in FIG. 7 to FIG. 19, and/or configured to support another process of the technology described in this specification.

In another possible implementation, the transceiver module 2001 in FIG. 20 may be replaced with a transceiver, and a function of the transceiver module 2001 may be integrated into the transceiver. The processing module 2002 may be replaced with a processor, and a function of the processing module 2002 may be integrated into the processor. Further, the communication apparatus 200 shown in FIG. 20 may further include a memory.

Alternatively, when the processing module 2002 is replaced with a processor, and the transceiver module 2001 is replaced with a transceiver, the communication apparatus 200 in embodiments of this application may be a communication apparatus 210 shown in FIG. 21. The processor may be a logic circuit 2101, and the transceiver may be an interface circuit 2102. Further, the communication apparatus 210 shown in FIG. 21 may further include a memory 2103.

An embodiment of this application further provides a computer program product. When the computer program product is executed by a computer, a function of any one of the foregoing method embodiments may be implemented.

An embodiment of this application further provides a computer program. When the computer program is executed by a computer, a function of any one of the foregoing method embodiments may be implemented.

An embodiment of this application further provides a computer-readable storage medium. All or some of procedures in the foregoing method embodiments may be implemented by a computer program instructing related hardware. The program may be stored in the foregoing computer-readable storage medium. When the program is executed, the procedures in the foregoing method embodiments may be performed. The computer-readable storage medium may be an internal storage unit in the terminal in any one of the foregoing embodiments (including a data transmit end and/or a data receive end), for example, a hard disk or memory of the terminal. The foregoing computer-readable storage medium may alternatively be an external storage device of the foregoing terminal, for example, a plug-in hard disk, a smart memory card (smart media card, SMC), a secure digital (secure digital, SD) card, or a flash card (flash card) that is configured on the foregoing terminal. Further, the computer-readable storage medium may further include both an internal storage unit and an external storage device of the foregoing terminal. The computer-readable storage medium is configured to store the computer program and other programs and data required by the foregoing terminal. The computer-readable storage medium may be further configured to temporarily store data that has been output or is to be output.

It should be noted that, in the specification, claims, and accompanying drawings of this application, the terms "first", "second", and the like are intended to distinguish between different objects but do not indicate a particular sequence. "First" and "second" are merely intended for description, and shall not be understood as an indication or implication of relative importance or an implicit indication of a quantity of indicated technical features. Therefore, a feature limited by "first" or "second" may explicitly or implicitly include one or more features. In the descriptions of embodiments, unless otherwise specified, "a plurality of" means two or more.

In addition, the terms "including" and "having" and any other variants thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

It should be understood that in this application, "at least one (item)" means one or more. "A plurality of" means two or more than two. "At least two (items)" means two, three, or more than three. "And/or" is used to describe an association relationship between associated objects, and indicates that three relationships may exist. For example, "A and/or B" may represent three cases: Only A exists, only B exists, and both A and B exist, where A and B may be singular or plural. The character "/" generally indicates an "or" relationship between the associated objects. "At least one of the following items (pieces)" or a similar expression thereof means any combination of these items, including any combination of singular items (pieces) or plural items (pieces). For example, at least one item (piece) of a, b, or c may indicate a, b, c, a and b, a and c, b and c, or a, b, and c, where a, b, and c may be singular or plural. Both "when ..." and "if" mean that corresponding processing is performed in an objective case, are not intended to limit time, do not require a determining action during implementation, and do not mean that there is another limitation.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In this application, "sending information to ... (a terminal device)" may be understood as that a destination of the information is the terminal device, and may include directly or indirectly sending information to the terminal device. "Receiving information from ... (a terminal device)" may be understood as that a source of the information is the terminal device, and may include directly or indirectly receiving the information from the terminal device. Information may undergo necessary processing, for example, a format change, between the source for sending the information and the destination. However, the destination may understand valid information from the source.

Based on the foregoing descriptions of the implementations, a person skilled in the art may clearly understand that for the purpose of convenient and brief descriptions, division into the foregoing functional modules is merely used as an example for descriptions. During actual application, the foregoing functions can be allocated to different functional modules for implementation based on a requirement, in other words, an inner structure of an apparatus is divided into different functional modules to implement all or a part of the functions described above.

In the several embodiments provided in this application, it should be understood that the disclosed apparatus and method may be implemented in other manners. For example, the described apparatus embodiment is merely an example. For example, the module or division into the units is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such understanding, the technical solutions of this application essentially or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in embodiments of this application. The foregoing storage medium includes any medium that can store program code, such as a USB flash drive, a removable hard disk, a ROM, a RAM, a magnetic disk, or an optical disc.

## Claims

1. A polar code encoding method, comprising:

    mapping, based on a reliability sequence, an information bit sequence whose length is k to k bits of a first sequence whose length is N, to obtain a second sequence, wherein a length of the reliability sequence is N, the second sequence comprises k information bit positions, x parity check PC bit positions, and N-k-x frozen bit positions, k≤K≤N, 1≤x, K is a maximum value of the length of the information bit sequence, and k, K, N, and x are all positive integers;

multiplying the second sequence by a first matrix to obtain a third sequence, wherein the first matrix is a matrix with all 0s below a diagonal and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 in the first matrix is less than or equal to N-K; and

performing polar encoding on the third sequence to obtain a fourth sequence.

2. The method according to claim 1, wherein multiplying the second sequence by the first matrix to obtain the third sequence comprises:

determining, based on the first matrix, one or more PC bit positions and bits checked by the PC bit positions; and
determining a value of the PC bit position in the second sequence based on a value of the bit checked by the PC bit position, to obtain the third sequence.

3. The method according to claim 1 or 2, wherein
the reliability sequence is determined based on one or more of the following: reliability, a code spectrum, and a performance optimization result.

4. The method according to any one of claims 1 to 3, wherein
a column weight of the first matrix is less than or equal to a first value.

5. The method according to any one of claims 1 to 4, wherein
the first matrix is:

$$
\begin{bmatrix}
10000000000000000000000000000000000 \\
01000000000000000000000000000000000 \\
00100000000000000000000000000000000 \\
00010000000000000000000000000000000 \\
00001000000000000000000000000000000 \\
00000100000000000000000000000000000 \\
00000010000000000000000000000000000 \\
00000001000000000000000000000000000 \\
00000000100000000000000000000000000 \\
00000000010000000000000000000000000 \\
00000000001000000000000000000000000 \\
00000000000100000100000000000000000 \\
00000000000010000000000000000000000 \\
00000000000001001010000000000000000 \\
00000000000000100000010000000000000 \\
00000000000000010010000000000000000 \\
00000000000000001000000000000000000 \\
00000000000000000100000000000000000 \\
00000000000000000010000000000000000 \\
00000000000000000001000000000000000 \\
00000000000000000000100000000000000 \\
00000000000000000000010000000000000 \\
00000000000000000000001001000000000 \\
00000000000000000000000100000000000 \\
00000000000000000000000010000000000 \\
00000000000000000000000001000000000 \\
00000000000000000000000000100000000 \\
00000000000000000000000000010000000 \\
00000000000000000000000000001000000 \\
00000000000000000000000000000100000 \\
00000000000000000000000000000010000 \\
00000000000000000000000000000001000 \\
00000000000000000000000000000000100 \\
00000000000000000000000000000000010 \\
00000000000000000000000000000000001
\end{bmatrix}.
$$

6. The method according to any one of claims 1 to 4, wherein the first matrix is:

```
⎡1000000000000000000000000000000⎤
 0100000000000000000000000000000
 0010000000000000000000000000000
 0001000000000000000000000000000
 0000100000000000000000000000000
 0000010000000000000000000000000
 0000001000000000000000000000000
 0000000100000000000000000000000
 0000000010000000000000000000000
 0000000001000000000000000000000
 0000000000100000000000000000000
 0000000000010000000010000000000
 0000000000001000000000000000000
 0000000000000100000000000100000
 0000000000000010000101000100000
 0000000000000001000000000000000
 0000000000000000100000000000000   .
 0000000000000000010000000000000
 0000000000000000001000000000000
 0000000000000000000100000000000
 0000000000000000000010000000000
 0000000000000000000001000000000
 0000000000000000000000100000000
 0000000000000000000000010000000
 0000000000000000000000001001000000
 0000000000000000000000000100000000
 0000000000000000000000000010000000
 0000000000000000000000000001000000
 0000000000000000000000000000100000
 0000000000000000000000000000010000
 0000000000000000000000000000001000
 0000000000000000000000000000000100
 0000000000000000000000000000000010
⎣0000000000000000000000000000000001⎦
```

7. The method according to any one of claims 1 to 6, wherein
the third sequence comprises the one or more PC bit positions, and a difference between a number of the PC bit position and a number of the bit checked by the PC bit position is a prime number.

8. The method according to claim 7, wherein
the PC bit position of the third sequence is one or more of the following bits in the third sequence: 16, 18, 21, or 25.

9. The method according to claim 8, wherein

when the PC bit position is the $16^{th}$ bit in the third sequence, the bit checked by the PC bit position is a $13^{th}$ bit in the third sequence; or
when the PC bit position is the $18^{th}$ bit in the third sequence, the bit checked by the PC bit position is one or more of the following bits in the third sequence: 11, 13, and 15; or
when the PC bit position is the $21^{st}$ bit in the third sequence, the bit checked by the PC bit position is a $14^{th}$ bit in the third sequence; or
when the PC bit position is the $25^{th}$ bit in the third sequence, the bit checked by the PC bit position is a $22^{nd}$ bit in the third sequence.

10. The method according to claim 7, wherein
the PC bit position of the third sequence is one or more of the following bits in the third sequence: 19, 21, 25, or 26.

11. The method according to claim 10, wherein

when the PC bit position is the $19^{th}$ bit in the third sequence, the bit checked by the PC bit position is a $14^{th}$ bit in the third sequence; or
when the PC bit position is the $21^{st}$ bit in the third sequence, the bit checked by the PC bit position is one or more of the following bits in the third sequence: 11 and 14; or
when the PC bit position is the $25^{th}$ bit in the third sequence, the bit checked by the PC bit position is one or more of the following bits in the third sequence: 14 and 22; or
when the PC bit position is the $26^{th}$ bit in the third sequence, the bit checked by the PC bit position is a $13^{th}$ bit in the third sequence.

12. The method according to any one of claims 1 to 11, wherein the method further comprises:

performing interleaving processing on the fourth sequence based on a first interleaving pattern, to obtain a fifth sequence; and
performing rate matching on the fifth sequence to obtain a first rate matching sequence.

13. The method according to claim 12, wherein

the first interleaving pattern indicates to place a value of an $A^{th}$ bit of the fourth sequence in a $B^{th}$ bit of the fifth sequence through swapping; and
a mapping relationship between A and B is: (5, 31), (26, 30), (11, 29), (9, 28), (28, 27), (7, 26), (30, 25), (16, 24), (31, 23), (21, 22), (10, 21), (24, 20), (27, 19), (6, 18), (3, 17), (12, 16), (17, 15), (8, 14), (13, 13), (0, 12), (2, 11), (1, 10), (4, 9), (14, 8), (25, 7), (23, 6), (22, 5), and (19, 4).

14. The method according to claim 12, wherein

the first interleaving pattern indicates to place a value of an $A^{th}$ bit of the fourth sequence in a $B^{th}$ bit of the fifth sequence through swapping; and
a mapping relationship between A and B is: (4, 31), (22, 30), (27, 29), (17, 28), (8, 27), (2, 26), (15, 25), (21, 24), (29, 23), (23, 22), (6, 21), (26, 20), (20, 19), (7, 18), (0, 17), (13, 16), (19, 15), (11, 14), (14, 13), (16, 12), (25, 11), (3, 10), (10, 9), (5, 8), (12, 7), (1, 6), (18, 5), and (24, 4).

15. The method according to any one of claims 1 to 11, wherein the method further comprises:

performing interleaving processing on the fourth sequence based on a second interleaving pattern, to obtain a sixth sequence; and
performing rate matching on the sixth sequence to obtain a second rate matching sequence.

16. The method according to claim 15, wherein the second interleaving pattern indicates to place a value of an $A^{th}$ bit of the fourth sequence in a $B^{th}$ bit of the sixth sequence through swapping; and

a mapping relationship between A and B is: (12, 31), (9, 30), (19, 29), (18, 28), (1, 27), (15, 26), (14, 25), (29, 24), (16, 23), (10, 22), (28, 21), (23, 20), (20, 19), (6, 18), (21, 17), (7, 16), (2, 15), (25, 14), (0, 13), (3, 12), (5, 11), (31, 10), (30, 9), (4, 8), (22, 7), (13, 6), (27, 5), and (8, 4); or
a mapping relationship between A and B is: (18, 31), (29, 30), (9, 29), (12, 28), (27, 27), (22, 26), (23, 25), (26, 24), (4, 23), (0, 22), (7, 21), (14, 20), (8, 19), (19, 18), (1, 17), (21, 16), (13, 15), (11, 14), (17, 13), (20, 12), (16, 11), (15, 10), (6, 9), (10, 8), (28, 7), (25, 6), and (24, 5); or
a mapping relationship between A and B is: (2, 31), (20, 30), (12, 29), (25, 28), (8, 27), (22, 26), (16, 25), (5, 24), (29, 23), (14, 22), (23, 21), (15, 20), (3, 19), (11, 18), (10, 17), (17, 16), (0, 15), (30, 14), (18, 13), (27, 12), (4, 11), (19, 10), (21, 9), (6, 8), (26, 7), and (9, 6); or
a mapping relationship between A and B is: (19, 31), (23, 30), (16, 29), (18, 28), (29, 27), (0, 26), (21, 25), (8, 24), (11, 23), (4, 22), (13, 21), (2, 20), (20, 19), (24, 18), (25, 17), (6, 16), (28, 15), (14, 14), (10, 13), (9, 12), (31, 11), (26, 10), (7, 9), (17, 8), and (1, 7); or
a mapping relationship between A and B is: (7, 31), (9, 30), (19, 29), (26, 28), (31, 27), (21, 26), (27, 25), (2, 24), (23, 23), (17, 22), (10, 21), (30, 20), (25, 19), (24, 18), (0, 17), (16, 16), (4, 15), (11, 14), (20, 13), (12, 12), (29, 11), (18, 10), (13, 9), and (3, 8); or

a mapping relationship between A and B is: (15, 31), (16, 30), (9, 29), (14, 28), (17, 27), (24, 26), (21, 25), (20, 24), (5, 23), (1, 22), (7, 21), (30, 20), (11, 19), (6, 18), (2, 17), (3, 16), (8, 15), (22, 14), (12, 13), (23, 12), (19, 11), (10, 10), and (29, 9); or

a mapping relationship between A and B is: (17, 31), (21, 30), (15, 29), (14, 28), (4, 27), (24, 26), (8, 25), (29, 24), (19, 23), (16, 22), (7, 21), (2, 20), (9, 19), (25, 18), (26, 17), (23, 16), (28, 15), (30, 14), (13, 13), (6, 12), (22, 11), and (0, 10); or

a mapping relationship between A and B is: (28, 31), (29, 30), (14, 29), (26, 28), (8, 27), (23, 26), (24, 25), (30, 24), (0, 23), (31, 22), (10, 21), (5, 20), (20, 19), (4, 18), (16, 17), (12, 16), (9, 15), (21, 14), (1, 13), (11, 12), and (22, 11); or

a mapping relationship between A and B is: (22, 31), (19, 30), (28, 29), (9, 28), (4, 27), (6, 26), (14, 25), (11, 24), (3, 23), (13, 22), (0, 21), (15, 20), (26, 19), (24, 18), (27, 17), (18, 16), (21, 15), (17, 14), (20, 13), and (12, 12).

**17.** The method according to claim 15, wherein

the second interleaving pattern indicates to place a value of an $A^{th}$ bit of the fourth sequence in a $B^{th}$ bit of the sixth sequence through swapping; and

a mapping relationship between A and B is: (5, 31), (11, 30), (24, 29), (30, 28), (13, 27), (20, 26), (22, 25), (3, 24), (4, 23), (25, 22), (31, 21), (6, 20), (10, 19), (8, 18), (21, 17), (15, 16), (9, 15), (2, 14), (0, 13), (27, 12), (14, 11), (16, 10), (17, 9), (23, 8), (28, 7), (26, 6), (1, 5), and (7, 4); or

a mapping relationship between A and B is: (16, 31), (28, 30), (10, 29), (30, 28), (19, 27), (7, 26), (13, 25), (9, 24), (11, 23), (6, 22), (8, 21), (26, 20), (21, 19), (20, 18), (23, 17), (25, 16), (0, 15), (17, 14), (27, 13), (22, 12), (18, 11), (15, 10), (5, 9), (12, 8), (2, 7), (29, 6), and (24, 5); or

a mapping relationship between A and B is: (9, 31), (19, 30), (11, 29), (12, 28), (21, 27), (0, 26), (29, 25), (2, 24), (4, 23), (31, 22), (10, 21), (1, 20), (22, 19), (7, 18), (24, 17), (30, 16), (20, 15), (3, 14), (28, 13), (13, 12), (14, 11), (8, 10), (6, 9), (5, 8), (17, 7), and (18, 6); or

a mapping relationship between A and B is: (11, 31), (25, 30), (31, 29), (27, 28), (14, 27), (0, 26), (22, 25), (19, 24), (18, 23), (3, 22), (20, 21), (2, 20), (4, 19), (17, 18), (23, 17), (24, 16), (12, 15), (1, 14), (7, 13), (10, 12), (28, 11), (26, 10), (6, 9), (5, 8), and (8, 7); or

a mapping relationship between A and B is: (7, 31), (12, 30), (2, 29), (5, 28), (26, 27), (6, 26), (27, 25), (24, 24), (4, 23), (19, 22), (1, 21), (29, 20), (9, 19), (8, 18), (13, 17), (11, 16), (28, 15), (10, 14), (25, 13), (16, 12), (30, 11), (0, 10), (21, 9), and (3, 8); or

a mapping relationship between A and B is: (7, 31), (30, 30), (17, 29), (16, 28), (19, 27), (6, 26), (29, 25), (18, 24), (10, 23), (3, 22), (24, 21), (9, 20), (21, 19), (28, 18), (31, 17), (12, 16), (23, 15), (2, 14), (15, 13), (4, 12), (27, 11), (20, 10), and (25, 9); or

a mapping relationship between A and B is: (28, 31), (25, 30), (17, 29), (6, 28), (11, 27), (21, 26), (27, 25), (30, 24), (3, 23), (1, 22), (4, 21), (8, 20), (15, 19), (26, 18), (29, 17), (18, 16), (9, 15), (19, 14), (2, 13), (20, 12), (23, 11), and (10, 10); or

a mapping relationship between A and B is: (23, 31), (30, 30), (3, 29), (28, 28), (14, 27), (19, 26), (9, 25), (16, 24), (29, 23), (13, 22), (26, 21), (12, 20), (18, 19), (0, 18), (15, 17), (4, 16), (20, 15), (1, 14), (25, 13), (31, 12), and (21, 11); or

a mapping relationship between A and B is: (1, 31), (24, 30), (14, 29), (15, 28), (25, 27), (12, 26), (26, 25), (13, 24), (27, 23), (31, 22), (8, 21), (5, 20), (20, 19), (21, 18), (3, 17), (28, 16), (17, 15), (6, 14), (19, 13), and (11, 12).

**18.** A communication apparatus, comprising:

a processing module, configured to map, based on a reliability sequence, an information bit sequence whose length is k to k bits of a first sequence whose length is N, to obtain a second sequence, wherein a length of the reliability sequence is N, the second sequence comprises k information bit positions, x parity check PC bit positions, and N-k-x frozen bit positions, $k \leq K \leq N$, $1 \leq x$, K is a maximum value of the length of the information bit sequence, and k, K, N, and x are all positive integers, wherein

the processing module is further configured to multiply the second sequence by a first matrix to obtain a third sequence, wherein the first matrix is a matrix with all 0s below a diagonal and all 1s on the diagonal, a column weight of a column corresponding to the PC bit position in the first matrix is greater than 1, a column weight of a column corresponding to the frozen bit position or the information bit position is equal to 1, and a quantity of columns whose column weights are greater than 1 in the first matrix is less than or equal to N-K; and

the transceiver module, further configured to perform polar encoding on the third sequence to obtain a fourth sequence.

19. A communication apparatus, wherein the communication apparatus comprises a processor; and the processor is configured to run a computer program or instructions, to enable the communication apparatus to perform the polar code encoding method according to any one of claims 1 to 17.

20. A computer-readable storage medium, wherein the computer-readable storage medium stores computer instructions or a program, and when the computer instructions or the program is run on a computer, the polar code encoding method according to any one of claims 1 to 17 is performed.

21. A computer program product, wherein the computer program product comprises computer instructions, and when a part or all of the computer instructions are run on a computer, the polar code encoding method according to any one of claims 1 to 17 is performed.

Required when a code
length is not equal to N

| Enumeration of mask vectors |
|---|

| Simple decision | → | High-order zero padding processing | → | Interleaving processing | → | Interleaving processing | → | FHT | → | Determine an information bit sequence |

FIG. 1

| F | F | F | I | F | I | I | S | F | PC | I | I | PC | I | I | S |
|---|---|---|---|---|---|---|---|---|----|---|---|----|---|---|---|

| F | Frozen bit position | | I | Information bit position | | PC | PC bit position | | S | Rate matching shortened bit position |
|---|---|---|---|---|---|---|---|---|---|---|

FIG. 2

FIG. 3

FIG. 4

Transmit end device (source) → Source encoding → Channel encoding → Modulation → Channel → Demodulation → Channel decoding → Source decoding → Receive end device (destination)

FIG. 5

600

601                                    607

| Processor | | Processor |
| CPU 0 | | CPU 0 |
| CPU 1 | | CPU 1 |

604

Communication
line 603

Memory

602          605          606

| Transceiver | | Output device | | Input device |

FIG. 6

| A transmit end device maps, based on a reliability sequence, an information bit sequence whose length is k to k bits of a first sequence whose length is N, to obtain a second sequence | 701 |

| The transmit end device multiplies the second sequence by a first matrix to obtain a third sequence | 702 |

| The transmit end device performs polar encoding on the third sequence to obtain a fourth sequence | 703 |

FIG. 7

FIG. 8

FIG. 9

Initialize search space of a puncturing position to 0 to N−1, where a quantity of punctures to 0

Select a position from the current search space as a newly added puncturing position

Obtain sequence performance of all sequences through simulation based on the current puncturing position

Take an average value of the sequence performance of all the sequences, to obtain metrics corresponding to different puncturing positions in a case of the current quantity of punctures

Reserve a list of puncturing positions corresponding to optimal metrics as candidate puncturing positions in the case of the current quantity of punctures

Update candidate search space of each list by deleting the current puncturing position from the search space

Increase the quantity of punctures by 1

Determine whether punctured data is less than a maximum quantity of punctures

Yes

No

Output a first interleaving pattern

FIG. 10

| E \ k | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 |
|---|---|---|---|---|---|---|---|---|---|---|---|---|---|---|---|---|---|---|---|---|---|---|---|---|---|---|---|---|
| 3 | 19 | 22 | 23 | 25 | 14 | 4 | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 4 | | 22 | 23 | 25 | 14 | 4 | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 5 | | | 23 | 25 | 14 | 4 | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 6 | | | | 25 | 14 | 4 | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 7 | | | | | 14 | 4 | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 8 | | | | | | 4 | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 9 | | | | | | | 1 | 2 | 0 | 13 | 8 | 17 | 12 | 3 | 6 | 27 | 24 | 10 | 21 | 31 | 16 | 30 | 7 | 28 | 9 | 11 | 26 | 5 |
| 10 | | | | | | | | 2 | 0 | 13 | 8 | 17 | 12 | 3 | 6 | 27 | 24 | 10 | 21 | 31 | 16 | 30 | 7 | 28 | 9 | 11 | 26 | 5 |
| 11 | | | | | | | | | 0 | 13 | 8 | 17 | 12 | 3 | 6 | 27 | 24 | 10 | 21 | 31 | 16 | 30 | 7 | 28 | 9 | 11 | 26 | 5 |

FIG. 11

49

EP 4 761 120 A1

| k \ E | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | 10 | 5 | 12 | 1 | 18 | 24 |
| 4 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | 10 | 5 | 12 | 1 | 18 | |
| 5 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | 10 | 5 | 12 | 1 | | |
| 6 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | 10 | 5 | 12 | | | |
| 7 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | 10 | 5 | | | | |
| 8 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | 10 | | | | | |
| 9 | 4 | 22 | 27 | 17 | 8 | 2 | 15 | 21 | 29 | 23 | 6 | 26 | 20 | 7 | 0 | 13 | 19 | 11 | 14 | 16 | 25 | 3 | | | | | | |
| 10 | 4 | 22 | 27 | 17 | 8 | 2 | 15 | 21 | 29 | 23 | 6 | 26 | 20 | 7 | 0 | 13 | 19 | 11 | 14 | 16 | 25 | | | | | | | |
| 11 | 4 | 22 | 27 | 17 | 8 | 2 | 15 | 21 | 29 | 23 | 6 | 26 | 20 | 7 | 0 | 13 | 19 | 11 | 14 | 16 | | | | | | | | |

FIG. 12

EP 4 761 120 A1

| E \ k | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 12 | 9 | 19 | 18 | 1 | 15 | 14 | 29 | 16 | 10 | 28 | 23 | 20 | 6 | 21 | 7 | 2 | 25 | 0 | 3 | 5 | 31 | 30 | 4 | 22 | 13 | 27 | 8 |
| 4 | 18 | 29 | 9 | 12 | 27 | 22 | 23 | 26 | 4 | 0 | 7 | 14 | 8 | 19 | 1 | 21 | 13 | 11 | 17 | 20 | 16 | 15 | 6 | 10 | 28 | 25 | 24 | |
| 5 | 2 | 20 | 12 | 25 | 8 | 22 | 16 | 5 | 29 | 14 | 23 | 15 | 3 | 11 | 10 | 17 | 0 | 30 | 18 | 27 | 4 | 19 | 21 | 6 | 26 | 9 | | |
| 6 | 19 | 23 | 16 | 18 | 29 | 0 | 21 | 8 | 11 | 4 | 13 | 2 | 20 | 24 | 25 | 6 | 28 | 14 | 10 | 9 | 31 | 26 | 7 | 17 | 1 | | | |
| 7 | 7 | 9 | 19 | 26 | 31 | 21 | 27 | 2 | 23 | 17 | 10 | 30 | 25 | 24 | 0 | 16 | 4 | 11 | 20 | 12 | 29 | 18 | 13 | 3 | | | | |
| 8 | 15 | 16 | 9 | 14 | 17 | 24 | 21 | 20 | 5 | 1 | 7 | 30 | 11 | 6 | 2 | 3 | 8 | 22 | 12 | 23 | 19 | 10 | 29 | | | | | |
| 9 | 17 | 21 | 15 | 14 | 4 | 24 | 8 | 29 | 19 | 16 | 7 | 2 | 9 | 25 | 26 | 23 | 28 | 30 | 13 | 6 | 22 | 0 | | | | | | |
| 10 | 28 | 29 | 14 | 26 | 8 | 23 | 24 | 30 | 0 | 31 | 10 | 5 | 20 | 4 | 16 | 12 | 9 | 21 | 1 | 11 | 22 | | | | | | | |
| 11 | 22 | 19 | 28 | 9 | 4 | 6 | 14 | 11 | 3 | 13 | 0 | 15 | 26 | 24 | 27 | 18 | 21 | 17 | 20 | 12 | | | | | | | | |

FIG. 13

| k\E | 31 | 30 | 29 | 28 | 27 | 26 | 25 | 24 | 23 | 22 | 21 | 20 | 19 | 18 | 17 | 16 | 15 | 14 | 13 | 12 | 11 | 10 | 9 | 8 | 7 | 6 | 5 | 4 |
|---|---|---|---|---|---|---|---|---|---|---|---|---|---|---|---|---|---|---|---|---|---|---|---|---|---|---|---|---|
| 3 | 5 | 11 | 24 | 30 | 13 | 20 | 22 | 3 | 4 | 25 | 31 | 6 | 10 | 8 | 21 | 15 | 9 | 2 | 0 | 27 | 14 | 16 | 17 | 23 | 28 | 26 | 1 | 7 |
| 4 | 16 | 28 | 10 | 30 | 19 | 7 | 13 | 9 | 11 | 6 | 8 | 26 | 21 | 20 | 23 | 25 | 0 | 17 | 27 | 22 | 18 | 15 | 5 | 12 | 2 | 29 | 24 |  |
| 5 | 9 | 19 | 11 | 12 | 21 | 0 | 29 | 2 | 4 | 31 | 10 | 1 | 22 | 7 | 24 | 30 | 20 | 3 | 28 | 13 | 14 | 8 | 6 | 5 | 17 | 18 |  |  |
| 6 | 11 | 25 | 31 | 27 | 14 | 0 | 22 | 19 | 18 | 3 | 20 | 2 | 4 | 17 | 23 | 24 | 12 | 1 | 7 | 10 | 28 | 26 | 6 | 5 | 8 |  |  |  |
| 7 | 7 | 12 | 2 | 5 | 26 | 6 | 27 | 24 | 4 | 19 | 1 | 29 | 9 | 8 | 13 | 11 | 28 | 10 | 25 | 16 | 30 | 0 | 21 | 3 |  |  |  |  |
| 8 | 7 | 30 | 17 | 16 | 19 | 6 | 29 | 18 | 10 | 3 | 24 | 9 | 21 | 28 | 31 | 12 | 23 | 2 | 15 | 4 | 27 | 20 | 25 |  |  |  |  |  |
| 9 | 28 | 25 | 17 | 6 | 11 | 21 | 27 | 30 | 3 | 1 | 4 | 8 | 15 | 26 | 29 | 18 | 9 | 19 | 2 | 20 | 23 | 10 |  |  |  |  |  |  |
| 10 | 23 | 30 | 3 | 28 | 14 | 19 | 9 | 16 | 29 | 13 | 26 | 12 | 18 | 0 | 15 | 4 | 20 | 1 | 25 | 31 | 21 |  |  |  |  |  |  |  |
| 11 | 1 | 24 | 14 | 15 | 25 | 12 | 26 | 13 | 27 | 31 | 8 | 5 | 20 | 21 | 3 | 28 | 17 | 6 | 19 | 11 |  |  |  |  |  |  |  |  |

FIG. 14

K=4  E=5 to 32

FIG. 15

K=6  E=7 to 32

FIG. 16

K=7    E=8 to 32

FIG. 17

K=8    E=9 to 32

FIG. 18

K=11    E=12 to 32

Curve 1: LTE-RM code
Curve 2: Polar code

SNR required to reach BLER=0.01

1

2

E

**FIG. 19**

Communication apparatus
200

Transceiver module
2001

Processing module
2002

**FIG. 20**

Communication apparatus 210

Logic circuit
2101

Interface
circuit 2102

Memory 2103

**FIG. 21**

## INTERNATIONAL SEARCH REPORT

| International application No. |
|---|
| **PCT/CN2023/115283** |

### A. CLASSIFICATION OF SUBJECT MATTER

H03M 13/13(2006.01)i

According to International Patent Classification (IPC) or to both national classification and IPC

### B. FIELDS SEARCHED

Minimum documentation searched (classification system followed by classification symbols)

IPC:H03M

Documentation searched other than minimum documentation to the extent that such documents are included in the fields searched

Electronic data base consulted during the international search (name of data base and, where practicable, search terms used)

CNABS: CNTXT; VEN; USTXT; EPTXT; WOTXT; CNKI; IEEE: 极化码, 可靠, 冻结, 奇偶校验, 位, 矩阵, polar code, reliablity, frozen, parity check, bit, matrix

### C. DOCUMENTS CONSIDERED TO BE RELEVANT

| Category* | Citation of document, with indication, where appropriate, of the relevant passages | Relevant to claim No. |
|---|---|---|
| A | CN 112886969 A (HUAWEI TECHNOLOGIES CO., LTD.) 01 June 2021 (2021-06-01) description, paragraphs 61-177, and figures 1-10 | 1-21 |
| A | CN 112042139 A (SAMSUNG ELECTRONICS CO., LTD.) 04 December 2020 (2020-12-04) description, paragraphs 72-287, and figures 1-17 | 1-21 |
| A | CN 114614943 A (HUAWEI TECHNOLOGIES CO., LTD.) 10 June 2022 (2022-06-10) entire document | 1-21 |
| A | CN 111654291 A (CHONGQING UNIVERSITY OF POSTS AND TELECOMMUNICATIONS) 11 September 2020 (2020-09-11) entire document | 1-21 |
| A | US 2021075485 A1 (ZTE CORP.) 11 March 2021 (2021-03-11) entire document | 1-21 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **08 May 2024** | **11 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/115283**

| Patent document cited in search report | | | Publication date (day/month/year) | Patent family member(s) | | | Publication date (day/month/year) |
|---|---|---|---|---|---|---|---|
| CN | 112886969 | A | 01 June 2021 | WO | 2021103978 | A1 | 03 June 2021 |
| | | | | EP | 4050826 | A1 | 31 August 2022 |
| | | | | US | 2022286144 | A1 | 08 September 2022 |
| | | | | US | 11870457 | B2 | 09 January 2024 |
| CN | 112042139 | A | 04 December 2020 | US | 2019305887 | A1 | 03 October 2019 |
| | | | | US | 11095397 | B2 | 17 August 2021 |
| | | | | WO | 2019190281 | A1 | 03 October 2019 |
| | | | | EP | 3776951 | A1 | 17 February 2021 |
| | | | | KR | 20190114263 | A | 10 October 2019 |
| | | | | KR | 102541319 | B1 | 08 June 2023 |
| CN | 114614943 | A | 10 June 2022 | WO | 2022117061 | A1 | 09 June 2022 |
| | | | | EP | 4250610 | A1 | 27 September 2023 |
| | | | | US | 2023318739 | A1 | 05 October 2023 |
| CN | 111654291 | A | 11 September 2020 | CN | 111654291 | B | 01 August 2023 |
| US | 2021075485 | A1 | 11 March 2021 | EP | 4307598 | A2 | 17 January 2024 |
| | | | | EP | 4307598 | A3 | 03 April 2024 |
| | | | | SG | 11202004508 | PA | 29 June 2020 |
| | | | | US | 2023283346 | A1 | 07 September 2023 |
| | | | | BR | 112020009832 | A2 | 03 November 2020 |
| | | | | US | 11601176 | B2 | 07 March 2023 |
| | | | | ES | 2965611 | T3 | 16 April 2024 |
| | | | | EP | 3713105 | A1 | 23 September 2020 |
| | | | | EP | 3713105 | B1 | 25 October 2023 |
| | | | | FI | 3713105 | T3 | 10 November 2023 |
| | | | | WO | 2019096271 | A1 | 23 May 2019 |
| | | | | KR | 20200090194 | A | 28 July 2020 |
| | | | | KR | 102520788 | B1 | 11 April 2023 |
| | | | | JP | 2021503784 | A | 12 February 2021 |
| | | | | JP | 7213244 | B2 | 26 January 2023 |

Form PCT/ISA/210 (patent family annex) (July 2022)